(19) Europäisches Patentamt
European Patent Office
Office européen des brevets

(11) EP 3 466 709 B1

(12) **EUROPEAN PATENT SPECIFICATION**

(45) Date of publication and mention of the grant of the patent:
**01.06.2022 Bulletin 2022/22**

(21) Application number: **17806381.4**

(22) Date of filing: **17.05.2017**

(51) International Patent Classification (IPC):
***B41N 1/08*** *(2006.01)* ***B41N 3/03*** *(2006.01)*
***G03F 7/00*** *(2006.01)* ***G03F 7/09*** *(2006.01)*

(52) Cooperative Patent Classification (CPC):
**B41N 1/083; B41N 3/034; G03F 7/00; G03F 7/09;**
B41C 2210/04; B41C 2210/08

(86) International application number:
**PCT/JP2017/018502**

(87) International publication number:
**WO 2017/208823 (07.12.2017 Gazette 2017/49)**

(54) **ALUMINUM SUPPORT FOR LITHOGRAPHIC PRINTING PLATE AND LITHOGRAPHIC PRINTING PLATE ORIGINAL PLATE**

ALUMINIUMTRÄGER FÜR LITHOGRAPHIEDRUCKPLATTE UND ORIGINALPLATTE EINER LITHOGRAPHIEDRUCKPLATTE

SUPPORT EN ALUMINIUM POUR PLAQUE D'IMPRESSION LITHOGRAPHIQUE ET CLICHÉ ORIGINAL POUR PLAQUE D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.05.2016 JP 2016107035**

(43) Date of publication of application:
**10.04.2019 Bulletin 2019/15**

(73) Proprietor: **FUJIFILM Corporation**
**Tokyo 106-8620 (JP)**

(72) Inventors:
- **KATABAMI Shigehiro**
**Haibara-gun**
**Shizuoka 421-0396 (JP)**
- **NISHINO Go**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**JP-A- 2005 088 224**
**JP-A- 2006 289 969**
**JP-A- 2014 198 453**
**US-A1- 2006 223 005**
**US-A1- 2009 035 695**
**US-A1- 2012 189 959**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 466 709 B1

## Description

## BACKGROUND OF THE INVENTION

1. Field of the Invention

The present invention relates to an aluminum support for a planographic printing plate and a planographic printing plate precursor.

2. Description of the Related Art

A planographic printing method is a printing method using the fact that water and oil essentially do not mix together, and, on a printing plate surface of a planographic printing plate that is used in the planographic printing method, a region that stores water and thus repels oil-based ink (hereinafter, this region will be referred to as the "non-image area") and a region that repels water and thus stores oil-based ink (hereinafter, this region will be referred to as the "image area") are formed.

An aluminum support for a planographic printing plate which is used for a planographic printing plate is used so that a surface thereof plays a role of the non-image area, and thus there is a demand for a variety of conflicting performances such as excellent hydrophilicity and water retentivity and, furthermore, an excellent adhesiveness to an image-recording layer that is provided on the surface of the aluminum support. In a case in which the hydrophilicity of the support is too poor, ink is attached to the non-image area during printing, and thus the stains of a blanket cylinder, and, furthermore, so-called scumming are caused. In addition, in a case in which the water retentivity of the support is too poor, and a large amount of a dampening solution is not provided during printing, the clogging of a shadow portion is caused. Therefore, a so-called water allowance becomes narrow.

In order to obtain an aluminum support for a planographic printing plate having favorable performances described above, it is usual to grain a surface of an aluminum plate (a roughening treatment) to impart roughness.

For example, JP2004-114324A describes "a support for a planographic printing plate which is obtained by carrying out a roughening treatment including a mechanical roughening treatment and an anodization treatment on an aluminum plate, in which a content of aluminum in the aluminum plate is 95% by mass or more and less than 99.50% by mass, and a grain shape of a structure in which a large wave structure having an average wavelength of 5 to 100 $\mu$m, a medium wave structure having an average opening diameter of 0.5 to 5 $\mu$m, and a small wave structure having an average opening diameter of 0.01 to 0.20 $\mu$m are superimposed is provided on a surface." ([Claim 1]).

In addition, JP2004-114677A describes "a support for a planographic printing plate which is obtained by carrying out a roughening treatment and an anodization treatment on an aluminum plate, in which a central line average roughness $R_a$ is less than 0.55 $\mu$m, a grain shape of a surface thereof is a structure in which a large wave structure having an average wavelength of 5 to 100 $\mu$m, a medium wave structure having an average opening diameter of 0.5 to 5 $\mu$m, and a small wave structure having an average opening diameter of 0.01 to 0.2 $\mu$m are superimposed, and the number of recessed portions having a depth of 3 $\mu$m or more present on the surface is 10 to 60 recessed portions/mm$^2$." ([Claim 1]).

US 2012/189959 A1 discloses an aluminum support for a planographic printing plate.

## SUMMARY OF THE INVENTION

Meanwhile, recently, in response to the improvement of demanded performance for printing techniques, stricter performances have been demanded regarding a variety of performances (particularly, on-machine developability and plate wear resistance) of a plate precursor for planographic printing and a planographic printing plate that are obtained using a support for a planographic printing plate. Meanwhile, generally, on-machine developability and plate wear resistance have a trade-off relationship, and it is difficult to improve both performances.

As a result of studies regarding a variety of performances of plate precursors for planographic printing and planographic printing plates obtained using a well-known support for a planographic printing plate of the related art described in JP2004-114324A, JP2004-114677A, and the like, the present inventors found that the characteristics such as on-machine developability and plate wear resistance satisfy the loose demanded characteristics of the related art, but fail to satisfy currently-demanded characteristics and cannot always be satisfied in a practical sense.

Therefore, an object of the invention is to provide an aluminum support for a planographic printing plate and a planographic printing plate precursor which can be used to obtain a plate precursor for a planographic printing plate that is excellent in terms of plate wear resistance in the case of being used to produce a planographic printing plate and exhibits excellent on-machine developability.

As a result of intensive studies for achieving the above-described object, the present inventors found that, in a case in which an average depth of pits (recessed portions) formed on a surface is set in a predetermined range, and

an aluminum support satisfying a specific surface area-increase rate is used, a plate precursor for a planographic printing plate exhibiting excellent on-machine developability can be obtained, and the plate wear resistance is excellent in a case in which the plate precursor is used to produce a planographic printing plate and completed the invention.

That is, it was found that the above-described object can be achieved by the invention as defined in claims 1 to 6.

According to the invention, it is possible to provide an aluminum support for a planographic printing plate and a planographic printing plate precursor which can be used to obtain a plate precursor for a planographic printing plate that is excellent in terms of plate wear resistance in the case of being used to produce a planographic printing plate and exhibits excellent on-machine developability.

## BRIEF DESCRIPTION OF THE DRAWINGS

Fig. 1 is an image captured using a field emission scanning electron microscope that illustrates a cross section of an aluminum support for a planographic printing plate which is intended to describe a method for measuring a surface area-increase rate $\Delta S_{SEM}$ (%).

Fig. 2 is an explanatory view for specifying a cross-sectional curved line of the aluminum support for a planographic printing plate and any start point and any end point used to compute the surface area-increase rate $\Delta S_{SEM}$ (%) which is intended to describe the method for measuring the surface area-increase rate $\Delta S_{SEM}$ (%).

Fig. 3 is a graph illustrating an example of an alternating waveform and current waveform chart that is used in an electrochemical roughening treatment in production of the aluminum support for a planographic printing plate of the embodiment of the invention.

Fig. 4 is a side view illustrating an example of a radial-type cell in the electrochemical roughening treatment in which an alternating current is used in the production of the aluminum support for a planographic printing plate of the embodiment of the invention.

Fig. 5 is a side view illustrating a concept of a brush graining step that is used in a mechanical roughening treatment in the production of the aluminum support for a planographic printing plate of the embodiment of the invention.

Fig. 6 is a schematic view of an anodization treatment device that is used in an anodization treatment in the production of the aluminum support for a planographic printing plate of the embodiment of the invention.

## DESCRIPTION OF THE PREFERRED EMBODIMENTS

Hereinafter, the invention will be described in detail.

There will be cases in which constitutional requirements described below will be described on the basis of a typical embodiment of the invention, but the invention is not limited to such an embodiment.

Meanwhile, in the present specification, a numerical range expressed using "to" indicates a range including numerical values described before and after "to" as a lower limit value and an upper limit value.

[Aluminum support for planographic printing plate]

An aluminum support for a planographic printing plate of the embodiment of the invention (hereinafter, also abbreviated as the "aluminum support of the embodiment of the invention") is an aluminum support for a planographic printing plate, in which an average value of surface area-increase rates $\Delta S_{SEM}$ (%) is 200% or more, and an average value of pit depths $\Delta h_{SEM}$ (nm) is 400 nm or less.

<Surface area-increase rate $\Delta S_{SEM}$ (%)>

In the invention, the surface area-increase rate $\Delta S_{SEM}$ (%) refers to a value computed from Expression (1), and the average value of the surface area-increase rates $\Delta S_{SEM}$ (%) refers to an average value of individual values computed at 20 places using Expression (1).

$$\Delta S_{SEM}\ (\%) = (\text{length of surface line}/\text{length of standard straight line Y}) \times 100 \cdots (1)$$

In Expression (1), the length of the standard straight line Y is 1.0 μm.

In addition, in Expression (1), the length of the surface line is a length of a cross-sectional curved line in a cross section of the aluminum support for a planographic printing plate in a thickness direction between any start point in the cross-sectional curved line and an end point at which a length of the cross-sectional curved line from the start point is

minimized among any points in the cross-sectional curved line at which a straight line distance from the start point becomes equal to the length of the standard straight line Y.

Meanwhile, as the 20 places at which the surface area-increase rate is measured, places at which the surface lines (parts of the cross-sectional curved line) in which the surface area-increase rate $\Delta S_{SEM}$ (%) is computed are not superimposed with one another are selected.

Here, the "cross-sectional curved line in the cross section of the aluminum support for a planographic printing plate in the thickness direction" refers to a curved line extracted in the following order.

(1) Cross section processing

The aluminum support for a planographic printing plate is cut using a push cutter, then, the cut sample is embedded with a resin, and cross section processing is carried out using a cross-sectional specimen-producing device (CROSS SECTION POLISHER IB-19500CP, manufactured by JEOL Ltd.) at an accelerated voltage of 4 to 8 kV.

(2) Conductive treatment

The processed cross section is subjected to a conductive treatment and then observed using a field emission scanning electron microscope (FE-SEM) (S-4800 type or SU8030 type, manufactured by Hitachi High-Technologies Corporation) at an accelerated voltage of 2 to 5 kV and a magnification of 30,000 times, thereby obtaining a SEM image.

Meanwhile, the conductive treatment is not particularly limited, and examples thereof include treatments in which the cross section is coated with several nanometers of C, Pt-Pd, Pt, or the like using a deposition method, a sputtering method, or the like.

(3) Extraction

A binarization treatment is carried out on the obtained SEM image using image processing software (ImageJ), and a cross-sectional curved line is extracted from a surface shape of the sample.

Meanwhile, the binarization treatment is carried out under a condition in which a border between the embedded resin and the aluminum support for a planographic printing plate is visible to the naked eyes.

<Pit depth $\Delta h_{SEM}$ (nm)>

In the invention, the average value of the pit depths $\Delta h_{SEM}$ (nm) of the aluminum support refers to a length at which a length of a normal line that is drawn using a "cross-sectional curved line" extracted using the same method as for the above-described surface area-increase rate $\Delta S_{SEM}$ (%) to a 0.2 $\mu$m-long standard straight line Z having a start point and an end point on the cross-sectional curved line, from the standard straight line Z to the cross-sectional curved line is maximized.

In addition, the average value of the pit depths $\Delta h_{SEM}$ (nm) refers to an average value of lengths at which the length of the normal line, from the standard straight line Z to the cross-sectional curved line is maximized and which are measured on the basis of the standard straight line Z at 20 places.

Meanwhile, as the 20 places at which the length is measured, places at which the surface lines (parts of the cross-sectional curved line) divided by the start point and the end point of the standard straight line Z are not superimposed with one another are selected.

Next, a method of specifying the length of the surface line will be specifically described using Fig. 1 and Fig. 2.

Fig. 1 is an image (SEM image) captured using a FE-SEM that illustrates a cross section of the aluminum support for a planographic printing plate which is intended to describe a method for measuring the surface area-increase rate $\Delta S_{SEM}$ (%).

In addition, Fig. 2 illustrates a cross-sectional curved line X extracted using the above-described method from the SEM image of Fig. 1, and, in Fig. 2, the length of the surface line is a length of the cross-sectional curved line between any start point a in the cross-sectional curved line and an end point b at which a length of the cross-sectional curved line from the start point is minimized among any points in the cross-sectional curved line X at which a straight line distance from the start point becomes equal to the length (1.0 $\mu$m) of the standard straight line Y. In addition, the pit depth $\Delta h_{SEM}$ (nm) refers to a length at which a length of a normal line c drawn to a 0.2 $\mu$m-long standard straight line Z having a start point and an end point on the cross-sectional curved line X from the standard straight line Z to the cross-sectional curved line X is maximized.

In the invention, the average value of the surface area-increase rates $\Delta S_{SEM}$ is 200% or more, and the average value of the pit depths $\Delta h_{SEM}$ (nm) is 400 nm or less, and thus it is possible to obtain a plate precursor for a planographic printing plate exhibiting excellent on-machine developability. In addition, the plate wear resistance becomes favorable

in a case in which the aluminum support is used to produce a planographic printing plate.

The reason for the on-machine developability and the plate wear resistance becoming favorable as described above is not clear in detail, but is assumed as described below.

That is, it is considered that, in a case in which the average value of the surface area-increase rates $\Delta S_{SEM}$ is 200% or more, the surface area percentage of the aluminum support sufficiently improves, and adhesiveness between the aluminum support and the image-recording layer is further enhanced, whereby the plate wear resistance improves.

Particularly, it is considered that, in a case in which the aluminum support of the embodiment of the invention is used as an on-machine development-type plate precursor, the surface area percentage between the image-recording layer and the support sufficiently improves, and thus it is possible to sufficiently store a dampening solution that permeates the image-recording layer between the image-recording layer and the support, and the on-machine developability improves.

In the aluminum support of the embodiment of the invention, as described above, the average value of the surface area-increase rates $\Delta S_{SEM}$ (%) is 200% or more, and, from the viewpoint of the on-machine developability and the ink-removing property, the average value is preferably 200 to 1,500%, more preferably 200 to 1,200%, and still more preferably 200 to 800%.

In addition, in the aluminum support of the embodiment of the invention, as described above, the average value of the pit depths $\Delta h_{SEM}$ (nm) is 400 nm or less, and, from the viewpoint of the ink-removing property, the average value is preferably 300 nm or less and more preferably 10 to 250 nm.

In the invention, for the reason that the plate wear resistance becomes more favorable in a case in which the aluminum support is used to produce a planographic printing plate, a color difference of the surface of the aluminum support preferably satisfies $30 \le L^* \le 55$, $-4.0 \le a^* \le +4.0$, and $-4.0 \le b^* \le +4.0$ and more preferably satisfies $30 \le L^* \le 55$, $-1.0 \le a^* \le +1.0$, and $-1.0 \le b^* \le +1.0$ in the L*a*b* color space.

Meanwhile, the definitions of L*, a*, and b* are as described below; however, in the invention, it is possible to employ values measured using SM-3-SCH manufactured by Suga Test Instruments Co., Ltd.

Regarding the chromatic coordinate L*a*b*, values (tristimulus values X, Y, and Z of an article color by reflection) of the XYZ color space were obtained by turning data of an absolute reflection spectrum (absolute reflectivity in a spectrophotometer) into Expression (1) regulated in JIS Z8701, and, furthermore, values (brightness index L* and chromaticness indexes a* and b*) of the L*a*b* color space were computed by turning the tristimulus values X, Y, and Z into Expression (2) regulated in JIS Z8729.

Specifically, first, the values (tristimulus values X, Y, and Z of an article color by reflection) of the XYZ color space were obtained by turning the data of an absolute reflection spectrum (absolute reflectivity in a spectrophotometer) into Expression (1).

$$\left.\begin{aligned} X &= K\int_{410}^{720} S(\lambda)\bar{x}(\lambda)R(\lambda)d\lambda \\ Y &= K\int_{410}^{720} S(\lambda)\bar{y}(\lambda)R(\lambda)d\lambda \\ Z &= K\int_{410}^{720} S(\lambda)\bar{z}(\lambda)R(\lambda)d\lambda \end{aligned}\right\} \quad \cdots(1)$$

$$K = \frac{100}{\int_{410}^{720} S(\lambda)\bar{y}(\lambda)d\lambda}$$

Here, $S(\lambda)$: Spectral distribution of standard light being used for display of color $\bar{x}(\lambda),\bar{y}(\lambda),\bar{z}(\lambda)$: Color-matching function in XYZ color space $R(\lambda)$: Spectral reflectance factor

In addition, the brightness index L* of the L*a*b* color space was computed by turning the tristimulus value Y into Expression (2).

$$L^* = 116(Y/Y_n)^{1/3} - 16 \qquad Y/Y_n > 0.008856 \quad \cdots(2)$$

Here, X, Y, Z: Tristimulus values in XYZ system

$Y_n$: Y value by standard light of complete diffusion reflection surface

Here, in the L*a*b* color space, in a case in which $Y/Y_n$ is 0.008856 or less, Expression (3) is used.

$$L^* = 903.29(Y/Y_n) \qquad Y/Y_n \leqq 0.008856 \quad \cdots(3)$$

In addition, the chromaticness indexes a* and b* of the L*a*b* color space were computed by turning the tristimulus values X, Y, and Z into Expression (4).

$$\left.\begin{array}{ll} a^* = 500\left[(X/X_n)^{1/3} - (Y/Y_n)^{1/3}\right] & X/X_n > 0.008856 \\ b^* = 200\left[(Y/Y_n)^{1/3} - (Z/Z_n)^{1/3}\right] & Y/Y_n > 0.008856 \\ & Z/Z_n > 0.008856 \end{array}\right\} \cdots(4)$$

Here, X, Y, Z: Tristimulus values in XYZ system
$X_n$, $Y_n$, $Z_n$: Tristimulus values in XYZ system of complete diffusion reflection surface

Here, in a case in which there is a value of 0.008856 or less in $X/X_n$, $Y/Y_n$, and Z/Zn, the corresponding element of the cube root in Expression (4) is substituted with $7.787(X/X_n)+(16/116)$, $7.787(Y/Y_n)+(16/116)$, or $7.787(Z/Z_n)+(16/116)$.

The aluminum support of the embodiment of the invention is not particularly limited as long as the average value of the surface area-increase rates $\Delta S_{SEM}$ (%) is 200% or more and the average value of pit depths $\Delta h_{SEM}$ (nm) is 400 nm or less, but is preferably a support obtained by carrying out a roughening treatment, an anodization treatment, a hydrophilization treatment, or the like on an aluminum plate.

Hereinafter, the aluminum plate, the roughening treatment, the anodization treatment, the hydrophilization treatment, and the like will be described in detail.

[Aluminum plate]

An aluminum plate that is used in the invention is a metal plate including dimensionally stable aluminum as a main component (that is, 50% by mass or more) and is made of aluminum or an aluminum alloy. The aluminum plate is selected from a pure aluminum plate, an alloy plate including aluminum as a main component and a small amount of a different element, or an aluminum (alloy)-laminated or deposited plastic film or paper. Furthermore, the aluminum plate may be a complex sheet having an aluminum sheet bonded onto a polyethylene terephthalate film as described in JP1973-018327B (JP-S48-018327B).

In the following description, the above-exemplified plates made of aluminum or an aluminum alloy will be collectively referred to as the aluminum plate. The different elements included in the aluminum alloy are silicon, iron, manganese, copper, magnesium, chromium, zinc, bismuth, nickel, titanium, and the like, and a content of the different elements in the alloy is 10% by mass or less.

In the invention, the pure aluminum plate is preferred, but the manufacturing of completely pure aluminum is difficult due to smelting techniques, and thus the aluminum plate may slightly contain different elements.

The composition of the aluminum plate that is applied to the invention as described above is not specified, and it is possible to appropriately use well-known materials of the related art, for example, JIS A 1050, JIS A 1100, JIS A 3103, JIS A 3005, and the like.

Meanwhile, in the aluminum plate that is used in the invention and is a plate made of an aluminum alloy, the content of Al is preferably 95% by mass or more, and, as the element contained in a small amount, at least one element selected from the group consisting of Si, Fe, Ni, Mn, Cu, Mg, Cr, Zn, Bi, Ti, and V is preferably contained.

As described above, in the case of a preferred aspect of the aluminum alloy plate including Si, Fe, Cu, Mn, Mg, Zn, and Ti, the content of Si is preferably 0.00% to 1.00% by mass, more preferably 0.01% to 0.90% by mass, and still more preferably 0.03% to 0.80% by mass. The content of Fe is preferably 0.00% to 1.00% by mass, more preferably 0.01% to 0.50% by mass, and still more preferably 0.02% to 0.40% by mass. The content of Cu is preferably 0.00% to 0.50% by mass, more preferably 0.001% to 0.40% by mass, and still more preferably 0.005% to 0.30% by mass. The content of Mn is preferably 0.00% to 0.50% by mass, more preferably 0.00% to 0.40% by mass, and still more preferably 0.00% to 0.30% by mass. The content of Mg is preferably 0.00% to 0.50% by mass, more preferably 0.00% to 0.40% by mass, and still more preferably 0.00% to 0.30% by mass. The content of Zn is preferably 0.00% to 0.80% by mass, more preferably 0.00% to 0.60% by mass, and still more preferably 0.00% to 0.40% by mass. The content of Ti is preferably 0.00% to 0.30% by mass.

In addition, the aluminum plate that is used in the invention is, generally, treated while being continuously travelled in a web shape and has a width of approximately 400 mm to 2,000 mm and a thickness of approximately 0.1 mm to 0.6 mm. This width or thickness can be appropriately changed depending on the size of a printer, the size of a

printing plate, and the desire of a user.

[Roughening treatment]

The roughening treatment is a step of carrying out a roughening treatment including an electrochemical roughening treatment on the surface of the above-described aluminum plate.
The roughening treatment is preferably carried out prior to an anodization treatment described below, but may not be particularly carried out in a case in which the surface of the aluminum plate already has a preferred surface shape.
As the roughening treatment, generally, only an electrochemical roughening treatment may be carried out, but an electrochemical roughening treatment and a mechanical roughening treatment and/or a chemical roughening treatment may be carried out in combination.
In the case of carrying out a mechanical roughening treatment and an electrochemical roughening treatment in combination, the electrochemical roughening treatment is preferably carried out after the mechanical roughening treatment.
In the invention, the electrochemical roughening treatment is preferably carried out in an acidic aqueous solution of nitric acid, hydrochloric acid, or the like.
In the invention, a variety of conditions of the mechanical roughening treatment are not particularly limited, but the mechanical roughening treatment can be carried out according to, for example, a method described in JP1975-040047B (JP-S50-040047B). The mechanical roughening treatment can be carried out by a brush grain treatment in which a pumice stone suspension is used or can be carried out in a transfer mode.
In addition, the chemical roughening treatment is also not particularly limited and can be carried out according to a well-known method.
After the mechanical roughening treatment, the following chemical etching treatment is preferably carried out.
The chemical etching treatment that is carried out after the mechanical roughening treatment is carried out in order to make an edge portion of an uneven shape of the surface of the aluminum plate smooth, prevent the dragging of an ink during printing, improve the stain resistance of a planographic printing plate, and remove an unnecessary article such as abrading material particles remaining on the surface.
As the chemical etching treatment, etching by an acid or etching by an alkali is known; however, as a method that is particularly excellent in terms of the etching efficiency, a chemical etching treatment using an alkali solution (hereinafter, also referred to as the "alkali etching treatment") is exemplified.
An alkali agent that is used in the alkali solution is not particularly limited, and preferred examples thereof include caustic soda, caustic potash, sodium metasilicate, sodium carbonate, sodium aluminate, sodium gluconate, and the like.
In addition, the respective alkali agents may contain an aluminum ion. The concentration of the alkali solution is preferably 0.01% by mass or more and more preferably 3% by mass or more and is preferably 30% by mass or less and more preferably 25% by mass or less.
Furthermore, the temperature of the alkali solution is preferably room temperature or higher and more preferably 30°C or higher and is preferably 80°C or lower and more preferably 75°C or lower.
The etching amount is preferably 0.1 $g/m^2$ or more and more preferably 1 $g/m^2$ or more and is preferably 20 $g/m^2$ or less and more preferably 10 $g/m^2$ or less.
In addition, the treatment time is preferably two seconds to five minutes depending on the etching amount and more preferably two to ten seconds from the viewpoint of improving the productivity.
In the invention, in a case in which the alkali etching treatment is carried out after the mechanical roughening treatment, a chemical etching treatment using a low-temperature acidic solution (hereinafter, also referred to as the "desmut treatment") is preferably carried out in order to remove a product generated by the alkali etching treatment.
An acid that is used in the acidic solution is not particularly limited, and examples thereof include sulfuric acid, nitric acid, and hydrochloric acid. The concentration of the acidic solution is preferably 1% to 50% by mass. In addition, the temperature of the acidic solution is preferably 20°C to 80°C. In a case in which the concentration and the temperature of the acidic solution are in these ranges, the resistance to dotted antifoul of a planographic printing plate for which the aluminum support for a planographic printing plate of the embodiment of the invention is used further improves.
In the invention, the roughening treatment is a treatment that carries out the electrochemical roughening treatment after the mechanical roughening treatment and the chemical etching treatment as desired; however, even in a case in which the electrochemical roughening treatment is carried out without carrying out the mechanical roughening treatment, the chemical etching treatment can be carried out using an alkali aqueous solution such as caustic soda before the electrochemical roughening treatment. Therefore, an impurity and the like present near the surface of the aluminum plate can be removed.
The electrochemical roughening treatment easily imparts fine roughness (pits) to the surface of the aluminum plate and is thus suitable for the production of a planographic printing plate having an excellent printing property.

The electrochemical roughening treatment is carried out in an aqueous solution including nitric acid or hydrochloric acid as a main body using a direct current or an alternating current.

In addition, after the electrochemical roughening treatment, the following chemical etching treatment is preferably carried out. On the surface of the aluminum plate that has been subjected to the electrochemical roughening treatment, a smut or an intermetallic compound is present. In the chemical etching treatment that is carried out after the electrochemical roughening treatment, first, a chemical etching treatment using an alkali solution (alkali etching treatment) is preferably carried out in order to efficiently remove, particularly, a smut. Regarding a variety of conditions for the chemical etching treatment using an alkali solution, the treatment temperature is preferably 20°C to 80°C, and the treatment time is preferably 1 to 60 seconds. In addition, the alkali solution preferably contains an aluminum ion.

Furthermore, after the chemical etching treatment using an alkali solution is carried out after the electrochemical roughening treatment, the chemical etching treatment using a low-temperature acidic solution (desmut treatment) is preferably carried out in order to remove a product generated by the chemical etching treatment using an alkali solution.

In addition, even in a case in which the alkali etching treatment is not carried out after the electrochemical roughening treatment, the desmut treatment is preferably carried out in order to efficiently remove the smut.

In the invention, all of the above-described chemical etching treatments can be carried out using a dipping method, a shower method, a coating method, or the like and are not particularly limited.

[Anodization treatment]

The anodization treatment is a step of forming an oxide film of aluminum having micropores that extend in the depth direction (thickness direction) on the surface of the aluminum plate by carrying out an anodization treatment on the aluminum plate on which the above-described roughening treatment has been carried out.

The anodization treatment can be carried out using a method that has been carried out in the related art of this field.

In addition, the average diameter (average opening diameter) of the micropores formed in the anodization treatment is preferably approximately 4 to 14 nm and more preferably 5 to 10 nm.

In addition, the depth of the micropores formed in the anodization treatment is preferably approximately 480 to 1,980 nm and more preferably 680 to 1,480 nm.

The pore density of the micropores is not particularly limited, but the pore density is preferably 50 to 4,000 pores/$\mu m^2$ and more preferably 100 to 3,000 pores/$\mu m^2$. In a case in which the pore density is in this range, the plate wear resistance and the ink-removing property after being left to stand of a planographic printing plate to be obtained and the on-machine developability of the planographic printing plate precursor become more favorable.

The film thickness of an anode oxide film that is obtained by the anodization treatment is preferably 0.5 to 2 $\mu$m and more preferably 0.7 to 1.5 $\mu$m. When the film thickness is in the above-described range, the plate wear resistance, the ink-removing property after being left to stand, the resistance to dotted antifoul, and the truly cyclic void resistance of a planographic printing plate for which an aluminum support for a planographic printing plate to be obtained is used and the on-machine developability of the planographic printing plate precursor become more favorable.

Furthermore, the film amount of the anode oxide film being obtained by an anodization treatment step is preferably 0.5 to 4 g/$m^2$ and more preferably 1.5 to 3.5 g/$m^2$. When the film amount is in the above-described range, the plate wear resistance, the ink-removing property after being left to stand, the resistance to dotted antifoul, and the truly cyclic void resistance of a planographic printing plate for which an aluminum support for a planographic printing plate to be obtained is used and the on-machine developability of the planographic printing plate precursor become more favorable.

In the anodization treatment, an aqueous solution of sulfuric acid, phosphoric acid, oxalic acid, or the like can be mainly used as an electrolytic bath. Depending on cases, an aqueous solution or non-aqueous solution of chromic acid, sulfamic acid, benzene sulfonic acid, or the like or a combination of two or more thereof can also be used. In a case in which a direct current or an alternating current is caused to flow through the aluminum plate in the above-described electrolytic bath, it is possible to form an anode oxide film on the surface of the aluminum plate.

Meanwhile, the electrolytic bath may include an aluminum ion. The content of the aluminum ion is not particularly limited, but is preferably 1 to 10 g/L.

The conditions for the anodization treatment are appropriately set depending on an electrolytic solution being used; however, generally, the concentration of the electrolytic solution is appropriately in a range of 1% to 80% by mass (preferably 5% to 20% by mass), the liquid temperature is appropriately in a range of 5°C to 70°C (preferably 10°C to 60°C), the current density is appropriately in a range of 0.5 to 60 A/$dm^2$ (preferably 5 to 50 A/$dm^2$), the voltage is appropriately in a range of 1 to 100 V (preferably 5 to 50 V), and the electrolysis time is appropriately in a range of 1 to 100 seconds (preferably 5 to 60 seconds).

Among the above-described anodization treatments, particularly, a method of carrying out anodization at a high current density in sulfuric acid, which is described in the specification of GB1,412,768B is preferred.

[Hydrophilization treatment]

As the hydrophilization treatment, it is possible to use a well-known method described in Paragraphs [0109] to [0114] of JP2005-254638A.

Meanwhile, the hydrophilization treatment is preferably carried out using a method in which the aluminum plate is immersed in an aqueous solution of an alkali metallic silicate such as sodium silicate or potassium silicate, a method in which a hydrophilic undercoat is formed by applying a hydrophilic vinyl polymer or a hydrophilic compound, or the like.

The hydrophilization treatment using an aqueous solution of an alkali metallic silicate such as sodium silicate or potassium silicate can be carried out according to a method and an order described in the specifications of US2,714,066A and US3,181,461A.

The aluminum support of the embodiment of the invention is preferably a support obtained by carrying out individual treatments described as an A aspect or a B aspect below in an order described below on the above-described aluminum plate, and, particularly, the A aspect is preferred from the viewpoint of the plate wear resistance.

Meanwhile, water washing is desirably carried out between the individual treatments described below. However, in a case in which a liquid having the same composition is used in two steps (treatments) that are continuously carried out, water washing may not be carried out.

[A aspect]

(2) A chemical etching treatment in an alkali aqueous solution (first alkali etching treatment)
(3) A chemical etching treatment in an acidic aqueous solution (first desmut treatment)
(4) An electrochemical roughening treatment in an aqueous solution including nitric acid as a main body (first electrochemical roughening treatment)
(5) A chemical etching treatment in an alkali aqueous solution (second alkali etching treatment)
(6) A chemical etching treatment in an acidic aqueous solution (second desmut treatment)
(7) An electrochemical roughening treatment in an aqueous solution including hydrochloric acid as a main body (second electrochemical roughening treatment)
(8) A chemical etching treatment in an alkali aqueous solution (third alkali etching treatment)
(9) A chemical etching treatment in an acidic aqueous solution (third desmut treatment)
(10) Anodization treatment
(11) A hydrophilization treatment

[B aspect]

(2) The chemical etching treatment in an alkali aqueous solution (first alkali etching treatment)
(3) The chemical etching treatment in an acidic aqueous solution (first desmut treatment)
(12) An electrochemical roughening treatment in an aqueous solution including hydrochloric acid as a main body
(5) The chemical etching treatment in an alkali aqueous solution (second alkali etching treatment)
(6) The chemical etching treatment in an acidic aqueous solution (second desmut treatment)
(10) The anodization treatment
(11) The hydrophilization treatment

Meanwhile, before the treatment (2) of the A aspect and the B aspect, (1) the mechanical roughening treatment may be carried out as necessary. Meanwhile, from the viewpoint of the plate wear resistance and the like, each of the aspects preferably does not include the treatment (1).

Here, the mechanical roughening treatment, the electrochemical roughening treatment, the chemical etching treatment, the anodization treatment, and the hydrophilization treatment of (1) to (12) can be carried out using the same method as the above-described treatment methods and conditions, but are preferably carried out using treatment methods and conditions described below.

In the mechanical roughening treatment, a roughening treatment is preferably carried out mechanically using a rotary nylon brush roll having a hair diameter of 0.2 to 1.61 mm and a slurry liquid that is supplied to the surface of the aluminum plate.

As an abrading agent, a well-known abrading agent can be used, but silica sand, quartz, aluminum hydroxide, or a mixture thereof is preferred.

The specific weight of the slurry liquid is preferably 1.05 to 1.3. It is needless to say that a method in which the slurry liquid is sprayed, a method in which a wire brush is used, a method in which a surface shape of a rolling roll provided with roughness is transferred to the aluminum plate, or the like may also be used.

The concentration of the alkali aqueous solution that is used in the chemical etching treatment in the alkali aqueous solution is preferably 1% to 30% by mass, and the content of aluminum and an alloy component in the aluminum

alloy may be 0% to 10% by mass.

The alkali aqueous solution is preferably an aqueous solution particularly including caustic soda as a main body. The liquid temperature is preferably normal temperature to 95°C, and the treatment time is preferably 1 to 120 seconds.

After the end of the etching treatment, in order to prevent the treatment liquid from being brought to the next step, liquid draining using a nip roller and water washing by spraying are preferably carried out.

The amount of the aluminum plate dissolved in the first alkali etching treatment is preferably 0.5 to 30 g/$m^2$, more preferably 1.0 to 20 g/$m^2$, and still more preferably 3.0 to 15 g/$m^2$.

The amount of the aluminum plate dissolved in the second alkali etching treatment is preferably 0.001 to 30 g/$m^2$, more preferably 0.1 to 4 g/$m^2$, and still more preferably 0.2 to 1.5 g/$m^2$.

The amount of the aluminum plate dissolved in the third alkali etching treatment is preferably 0 to 30 g/$m^2$, more preferably 0 to 0.8 g/$m^2$, and still more preferably 0 to 0.3 g/$m^2$.

In the chemical etching treatments (the first to third desmut treatments) in the acidic aqueous solution, phosphoric acid, nitric acid, sulfuric acid, chromic acid, hydrochloric acid, or a mixed acid including two or more acids described above is preferably used.

The concentration of the acidic aqueous solution is preferably 0.5% to 60% by mass.

In addition, the amount of aluminum and the alloy component in the aluminum alloy dissolved in the acidic aqueous solution may be 0% to 5% by mass.

In addition, the liquid temperature is preferably normal temperature to 95°C, and the treatment time is preferably 1 to 120 seconds. After the end of the desmut treatment, in order to prevent the treatment liquid from being brought to the next step, liquid draining using a nip roller and water washing by spraying are preferably carried out.

The aqueous solution that is used in the electrochemical roughening treatment will be described.

As the aqueous solution including nitric acid as a main body which is used in the first electrochemical roughening treatment, an aqueous solution that is used in an ordinary electrochemical roughening treatment using a direct current or an alternating current can be used, and an aqueous solution obtained by adding one or more of hydrochloric acid or nitric acid compounds having a nitric acid ion such as aluminum nitrate, sodium nitrate, and ammonium nitrate; a hydrochloric acid ion such as aluminum chloride, sodium chloride, and ammonium chloride; or the like to 1 to 100 g/L of a nitric acid aqueous solution so that a concentration is from 1 g/L to saturation can be used.

In addition, in the aqueous solution including nitric acid as a main body, metal included in the aluminum alloy such as iron, copper, manganese, nickel, titanium, magnesium, and silica may be dissolved.

Specifically, a liquid obtained by adding aluminum chloride or aluminum nitrate to an aqueous solution of 0.5% to 2% by mass of nitric acid so that the concentration of an aluminum ion reaches 3 to 50 g/L is preferably used.

In addition, the temperature is preferably 10°C to 90°C and more preferably 40°C to 80°C.

Meanwhile, as the aqueous solution including hydrochloric acid as a main body which is used in the second electrochemical roughening treatment, an aqueous solution that is used in an ordinary electrochemical roughening treatment using a direct current or an alternating current can be used, and an aqueous solution obtained by adding one or more of hydrochloric acid or nitric acid compounds having a nitric acid ion such as aluminum nitrate, sodium nitrate, and ammonium nitrate; a hydrochloric acid ion such as aluminum chloride, sodium chloride, and ammonium chloride; or the like to 1 to 100 g/L of a hydrochloric acid aqueous solution so that a concentration is from 1 g/L to saturation can be used.

In addition, in the aqueous solution including hydrochloric acid as a main body, metal included in the aluminum alloy such as iron, copper, manganese, nickel, titanium, magnesium, and silica may be dissolved.

Specifically, a liquid obtained by adding aluminum chloride or aluminum nitrate to an aqueous solution of 0.5% to 2% by mass of hydrochloric acid so that the concentration of an aluminum ion reaches 3 to 50 g/L is preferably used.

In addition, the temperature is preferably 10°C to 60°C and more preferably 20°C to 50°C. Meanwhile, hypochlorous acid may also be added thereto.

Meanwhile, as the aqueous solution including hydrochloric acid as a main body which is used in the electrochemical roughening treatment in the hydrochloric acid aqueous solution in the B aspect, an aqueous solution that is used in an ordinary electrochemical roughening treatment using a direct current or an alternating current can be used, and an aqueous solution obtained by adding 0 to 30 g/L of sulfuric acid to 1 to 100 g/L of a hydrochloric acid aqueous solution can be used. In addition, an aqueous solution obtained by adding one or more of hydrochloric acid or nitric acid compounds having a nitric acid ion such as aluminum nitrate, sodium nitrate, and ammonium nitrate; a hydrochloric acid ion such as aluminum chloride, sodium chloride, and ammonium chloride; or the like to this solution so that a concentration is from 1 g/L to saturation can be used.

In addition, in the aqueous solution including hydrochloric acid as a main body, metal included in the aluminum alloy such as iron, copper, manganese, nickel, titanium, magnesium, and silica may be dissolved.

Specifically, a liquid obtained by adding aluminum chloride or aluminum nitrate to an aqueous solution of 0.5% to 2% by mass of nitric acid so that the concentration of an aluminum ion reaches 3 to 50 g/L is preferably used.

In addition, the temperature is preferably 10°C to 60°C and more preferably 20°C to 50°C. Meanwhile, hypochlorous acid may also be added thereto.

As the alternating current power supply waveform of the electrochemical roughening treatment, a sine wave, a square wave, a trapezoid wave, a triangle wave, or the like can be used. The frequency is preferably 0.1 to 250 Hz.

Fig. 3 is a graph illustrating an example of an alternating waveform and current waveform chart that is used in the electrochemical roughening treatment in a method for manufacturing the aluminum support for a planographic printing plate of the embodiment of the invention.

In Fig. 3, ta represents the anode reaction time, tc represents the cathode reaction time, tp represents the time taken for the current to reach the peak from zero, Ia represents the current at the peak on the anode cycle side, and Ic represents the current at the peak on the cathode cycle side. In a trapezoid wave, the time tp taken for the current to reach the peak from zero is preferably 1 to 10 msec. In a case in which tp is less than 1, due to the influence of the impedance of a power supply circuit, a great power supply voltage is required in the initial rise of the current waveform, and the facility cost of the power supply increases. In a case in which tp becomes longer than 10 msec, the influence of a component that is included in an electrolytic solution in a small amount is likely to increase, and it becomes difficult to carry out uniform roughening. Regarding the conditions of one cycle of an alternating current that is used for electrochemical roughening, it is preferable that the ratio tc/ta of the cathode reaction time tc to the anode reaction time ta of the aluminum plate is 1 to 20, the ratio Qc/Qa of the electric quantity Qc in the aluminum plate as the anode to the electric quantity Qa in the aluminum plate as the anode is 0.3 to 20, and the anode reaction time ta is in a range of 5 to 1,000 msec. tc/ta is more preferably 2.5 to 15. Qc/Qa is more preferably 2.5 to 15. The current density is preferably 10 to 200 $A/dm^2$ at the peak value of the trapezoid wave on both the anode cycle side Ia and the cathode cycle side Ic of the current. Ic/Ia is preferably in a range of 0.3 to 20. The sum of the electric quantities spent for the anode reaction of the aluminum plate at the end of electrochemical roughening is preferably 25 to 1,000 $C/dm^2$.

In the invention, as an electrolytic vessel that is used for electrochemical roughening using an alternating current, a well-known electrolytic vessel that is used for a surface treatment such as a vertical-type electrolytic vessel, a flat-type electrolytic vessel, or a radial-type electrolytic vessel can be used, but a radial-type electrolytic vessel as described in JP1993-195300A (JP-H5-195300A) is particularly preferred.

For electrochemical roughening using an alternating current, a device illustrated in Fig. 4 can be used.

Fig. 4 is a side view illustrating an example of a radial-type cell in the electrochemical roughening treatment in which an alternating current is used in the method for manufacturing the aluminum support for a planographic printing plate of the embodiment of the invention.

In Fig. 4, 50 represents a main electrolytic vessel, 51 represents an alternating current power supply, 52 represents a radial drum roller, 53a and 53b are main electrodes, 54 represents an electrolytic solution supply opening, 55 represents an electrolytic solution, 56 represents a slit, 57 represents an electrolytic solution flow path, 58 represents an auxiliary anode, 60 represents an auxiliary anode vessel, and W represents an aluminum plate. In the case of using two or more electrolytic vessels, the electrolysis conditions may be identical to or different from each other.

The aluminum plate W is immersed in the main electrolytic vessel 50, wound around the disposed radial drum roller 52, and electrolyzed using the main electrodes 53a and 53b that are connected to the alternating current power supply 51 in a transportation process. The electrolytic solution 55 is supplied from the electrolytic solution supply opening 54 to the electrolytic solution flow path 57 between the radial drum roller 52 and the main electrodes 53a and 53b through the slit 56. The aluminum plate W that has been treated in the main electrolytic vessel 50 is subsequently electrolyzed in the auxiliary anode vessel 60. In this auxiliary anode vessel 60, the auxiliary anode 58 is disposed opposite to the aluminum plate W, and the electrolytic solution 55 is supplied so as to flow through a space between the auxiliary anode 58 and the aluminum plate W.

Meanwhile, the electrochemical roughening treatments (the first and second electrochemical roughening treatments) may be a method in which a direct current is applied between the aluminum plate and the electrodes opposite thereto, thereby electrochemically roughening the aluminum plate.

[Drying treatment]

After an aluminum support for a planographic printing plate obtained through the above-described steps is obtained, a treatment for drying the surface of the aluminum support for a planographic printing plate (drying treatment) is preferably carried out before the provision of an image-recording layer described below.

The drying is preferably carried out after the final treatment of the surface treatment and then a water washing treatment and liquid draining using a nip roller. Specific conditions are not particularly limited, but the aluminum plate is preferably dried using hot air (50°C to 200°C), a cold air natural drying method, or the like.

[Planographic printing plate precursor]

It is possible to produce a planographic printing plate precursor of the embodiment of the invention by providing an image-recording layer such as a photosensitive layer or a thermosensitive layer exemplified below to the aluminum support for a planographic printing plate of the embodiment of the invention.
The image-recording layer is not particularly limited, and preferred examples thereof include conventional positive-type image-recording layers, conventional negative-type image-recording layers, photopolymer-type image-recording layers (photopolymerization-type photosensitive compositions), thermal positive-type image-recording layers, thermal negative-type image-recording layers, and untreated-type image-recording layers capable of on-machine development which are described in Paragraphs [0042] to [0198] of JP2003-001956A.
Hereinafter, preferred image-recording layers will be described in detail.

[Image-recording layer]

The image-recording layer that can be used in the planographic printing plate precursor of the embodiment of the invention is preferably an image-recording layer in which an image is formed by exposure and a non-exposed portion is removable using a printing ink and/or a dampening solution.
Specifically, the image-recording layer is preferably an image-recording layer having an infrared absorbent, a polymerization initiator, and a polymerizable compound and capable of recording by the irradiation with an infrared ray. In addition, the image-recording layer may be an image-recording layer having thermoplastic polymer particles and an infrared absorbent and capable of recording by the irradiation with an infrared ray, and the image-recording layer may have a polyglycerol compound.
In the planographic printing plate precursor of the embodiment of the invention, an exposed portion of the image-recording layer is cured by the irradiation with an infrared ray and forms a hydrophobic (lipophilic) region, and, at the beginning of printing, the non-exposed portion is rapidly removed from the support using a dampening solution, an ink, or an emulsion of a dampening solution and an ink.
Hereinafter, individual constituent components of the image-recording layer will be described.

<First aspect: image-recording layer having infrared absorbent, polymerization initiator, and polymerizable compound and capable of recording by irradiation with infrared ray>

(Infrared absorbent)

In the planographic printing plate precursor of the embodiment of the invention, in a case in which an image is formed using a laser emitting infrared rays of 760 to 1,200 nm as a light source, generally, an infrared absorbent is used.
The infrared absorbent has a function of converting absorbed heat to an infrared ray and a function of being excited by an infrared ray and migrating electron/energy to the polymerization initiator (radical generator) described below.
An infrared absorbent that can be used in the invention is a dye or pigment having the absorption maximum at a wavelength of 760 to 1,200 nm.
As a dye, a commercially available dye or a well-known dye described in a document, for example, "Dye Handbook" (edited by The Society of Synthetic Organic Chemistry, Japan and published on 1970) can be used.
Specific examples thereof include dyes such as azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex. For example, a dye disclosed in Paragraphs [0096] to [0107] of JP2009-255434A can be preferably used.
Meanwhile, as a pigment, a pigment described in Paragraphs [0108] to [0112] of JP2009-255434A can be used.

(Polymerization initiator)

The polymerization initiator is a compound that generates a radical using the energy of light, heat, or both and begins and accelerates the polymerization of a compound having a polymerizable unsaturated group, and, in the invention, a compound that generates a radical using heat (thermal radical generator) is preferably used.
As the polymerization initiator, a well-known thermopolymerization initiator, a compound having a bond having a small bond dissociation energy, a photopolymerization initiator, or the like can be used.
As the polymerization initiator, for example, a polymerization initiator described in Paragraphs [0115] to [0141] of JP2009-255434A can be used.
Meanwhile, as the polymerization initiator, an onium salt or the like can be used, and, from the viewpoint of reactivity and stability, an oxime ester compound, diazonium salt, iodonium salt, and sulfonium salt are exemplified as

preferred polymerization initiators.

The proportion of the polymerization initiator added can be set to 0.1% to 50% by mass, preferably set to 0.5% to 30% by mass, and particularly preferably set to 1% to 20% by mass of the total solid content constituting the image-recording layer. In this range, a favorable sensitivity and a favorable stain resistance of the non-image area during printing can be obtained.

(Polymerizable compound)

The polymerizable compound is an addition-polymerizable compound having at least one ethylenic unsaturated double bond and is selected from compounds having at least one and preferably two or more terminal ethylenic unsaturated bonds. In the invention, as the above-described compound, a compound broadly known in the technical field of the invention can be used without any particular limitation.

As the polymerizable compound, for example, a polymerizable compound exemplified in Paragraphs [0142] to [0163] of JP2009-255434A can be used.

In addition, a urethane-based addition-polymerizable compound that is manufactured using an addition reaction between isocyanate and a hydroxyl group is also preferred. Specific examples thereof include vinyl urethane compounds containing two or more polymerizable vinyl groups in one molecule which are described in JP1973-041708B (JP-S48-041708B) and obtained by adding a vinyl monomer containing a hydroxyl group represented by General Formula (A) to a polyisocyanate compound having two or more isocyanate groups in one molecule and the like.

$$CH_2=C(R^4)COOCH_2CH(R^5)OH \qquad (A)$$

(Here, $R^4$ and $R^5$ represent H or $CH_3$.)

The amount of the polymerizable compound used is preferably 5% to 80% by mass and more preferably in a range of 25% to 75% by mass of a non-volatile component in the image-recording layer. In addition, the polymerizable compound may be used singly or two or more polymerizable compounds may be jointly used.

(Binder polymer)

In the invention, in the image-recording layer, a binder polymer is used in order to improve the film-forming property of the image-recording layer.

As the binder polymer, a well-known binder polymer of the related art can be used without any limitation, and a polymer having a film property is preferred. Specific examples of the above-described binder polymer include an acrylic resin, a polyvinyl acetal resin, a polyurethane resin, a polyurea resin, a polyimide resin, a polyamide resin, an epoxy resin, a methacrylic resin, a polystyrene-based resin, a novolac-type phenol-based resin, a polyester resin, synthetic rubber, natural rubber, and the like.

The binder polymer may have a crosslinking property in order to improve the film hardness of an image area. In order to impart the crosslinking property to the binder polymer, a crosslinking functional group such as an ethylenic unsaturated bond needs to be introduced to a main chain or a side chain of a polymer. The crosslinking functional group may be introduced by copolymerization.

As the binder polymer, for example, a binder polymer disclosed in Paragraphs [0165] to [0172] of JP2009-255434A can also be used.

The content of the binder polymer is 5% to 90% by mass, preferably 5% to 80% by mass, and more preferably 10% to 70% by mass of the total solid content of the image-recording layer. In this range, a favorable strength and a favorable image-forming property of the image area can be obtained.

In addition, the polymerizable compound and the binder polymer are preferably used in an amount in which the mass ratio therebetween reaches 0.5/1 to 4/1.

(Surfactant)

In the image-recording layer, in order to accelerate the on-machine developability at the beginning of printing and improve the coating surface state, a surfactant is preferably used.

Examples of the surfactant include a nonionic surfactant, an anionic surfactant, a cationic surfactant, an amphoteric surfactant, a fluorine-based surfactant, and the like.

As the surfactant, for example, a surfactant disclosed in Paragraphs [0175] to [0179] of JP2009-255434A and the like can be used.

The surfactant can be used singly or two or more surfactants can be used in combination.

The content of the surfactant is preferably 0.001 % to 10% by mass and more preferably 0.01% to 5% by mass

of the total solid content of the image-recording layer.

To the image-recording layer, a variety of compounds other than the above-described substances may be further added as necessary. Examples thereof include a coloring agent, a print-out agent, a polymerization inhibitor, a higher fatty acid derivative, a plasticizer, inorganic fine particles, a low-molecular-weight hydrophilic compound, and the like disclosed in Paragraphs [0181] to [0190] of JP2009-255434A.

Meanwhile, in addition to the above-described aspects, the image-recording layer may also be produced using a photopolymerization-type photosensitive composition (photopolymer type) containing an addition-polymerizable compound, a photopolymerization initiator, and a polymer binding agent.

As the addition-polymerizable compound, an ethylenic unsaturated bond-containing compound capable of addition polymerization is preferably exemplified. The ethylenic unsaturated bond-containing compound is a compound having a terminal ethylenic unsaturated bond.

As the photopolymerization initiator, a variety of photopolymerization initiators or a joint use system (photoinitiation system) of two or more photopolymerization initiators can be appropriately selected and used depending on the wavelength of a light source being used.

<Second aspect: image-recording layer having thermoplastic polymer particles and infrared absorbent and capable of recording by irradiation with infrared ray>

(Thermoplastic polymer particles)

The average particle diameter of thermoplastic polymer particles is preferably 45 nm to 63 nm, more preferably 45 nm to 60 nm, still more preferably 45 nm to 59 nm, particularly preferably 45 nm to 55 nm, and most preferably 48 nm to 52 nm. In the present specification, the particle diameter is defined as a particle diameter measured by photon correlation spectrometry which is also known as quasi-elastic or dynamic light-scattering. This method is a convenient method for measuring particle diameters, and the values of measured particle diameters favorably coincide with particle diameters measured using a transmission electron microscope (TEM) as disclosed by Stanley D. Duke et al. in Calibration of Spherical Particles by Light Scattering in Technical Note-002B (May 15, 2000) (revised from a thesis published in Particulate Science and Technology 7, p. 223 to 228 (1989) on January 3, 2000).

The amount of the thermoplastic polymer particles in the image-recording layer is preferably 70% by mass to 85% by mass and more preferably 75% by mass to 85% by mass. The mass percentage of the thermoplastic polymer particles is determined regarding the masses of all of the components in the image-recording layer.

The thermoplastic polymer particles are preferably polyethylene, poly(vinyl)chloride, polymethyl (meth)acrylate, polyethyl (meth)acrylate, polyvinylidene chloride, poly(meth)acrylonitrile, polyvinylcarbazole, polystyrene, or a copolymer thereof. According to a preferred aspect, the thermoplastic polymer particles include a mixture including polystyrene or a derivative thereof, polystyrene, and poly(meth)acrylonitrile or a derivative thereof or a copolymer including polystyrene and poly(meth)acrylonitrile or a derivative thereof. The latter copolymer is capable of including at least 50% by mass of polystyrene and more preferably including at least 65% by mass of polystyrene. In order to obtain a sufficient resistance to an organic chemical such as hydrocarbon, the thermoplastic polymer particles preferably include at least 5% by mass of a nitrogen-containing unit as described in the specification of EP1,219,416B and more preferably include at least 30% by mass of a nitrogen-containing unit such as (meth)acrylonitrile. According to the most preferred aspect, the thermoplastic polymer particles are essentially made of a styrene and acrylonitrile unit in a mass ratio of 1:1 to 5:1 (styrene:acrylonitrile), for example, 2:1.

The weight-average molecular weight of the thermoplastic polymer particles is preferably in a range of 5,000 to 1,000,000 g/mol.

(Infrared absorbent)

The concentration of the infrared absorbent in the image-recording layer is preferably at least 6% by mass and more preferably at least 8% by mass of the weight of all of the components in the image-recording layer. A preferred IR-absorbing compound is a dye such as cyanine, merocyanine, indoaniline, oxonol, pyrylium, or squarylium dye or a pigment such as carbon black. Examples of suitable infrared absorbents are described in, for example, the specifications of EP823327B, EP978376B, EP1029667B, EP1053868B, and EP1093934B and WO97/039894A and WO00/029214A. A preferred compound is the following cyanine dye.

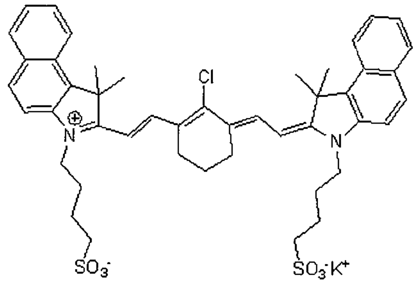

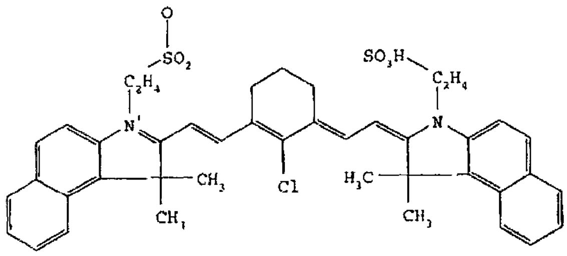

The image-recording layer is capable of further containing separate components. Examples thereof include well-known components such as an additional binding agent, polymer particles such as a matting agent and a spacer, a surfactant such as a perfluoro surfactant, silicon or titanium dioxide particles, a development inhibitor, a development accelerator, and a coloring agent. The addition of a coloring agent such as a dye or a pigment that imparts a visible color to the image-recording layer and remains in an exposed region of the image-recording layer after a treatment stage is particularly advantageous. Therefore, an image region that is not removed during the treatment stage forms a visible image on a printing plate, and the inspection of the printing plate that has been already developed in this stage becomes possible. Typical examples of contrast dyes thereof are amino-substituted tri- or diarylmethane dyes, for example, Crystal Violet, Methyl Violet, Victoria Pure Blue, Flexoblau 630, Basonylblau 640, Auramine, and Malachite Green. A dye discussed in detail in the detailed description of the specification of EP400,706B is also an appropriate contrast dye.

To the image-recording layer, in order for the improvement of on-machine developability and the film hardness of the image-forming layer, a hydrophilic resin can be added. The hydrophilic resin is preferably a hydrophilic resin that does not form a three-dimensional crosslinking due to the favorable on-machine developability.

The hydrophilic resin preferably has a hydrophilic group, for example, a hydroxyl group, a carboxyl group, a hydroxyethyl group, a hydroxypropyl group, an amino group, an aminoethyl group, an aminopropyl group, a carboxymethyl group, or the like.

Specific examples of the hydrophilic resin include gum arabic, casein, gelatin, soya gum, starch and derivatives thereof, hydroxyethyl cellulose, hydroxypropyl cellulose, methyl cellulose, carboxymethyl cellulose and salts thereof, cellulose derivatives such as cellulose acetate, alginic acid and alkali metal salts thereof, alkaline earth metal salts or ammonium salts, water-soluble urethane resins, water-soluble polyester resins, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene oxides, poly(propylene oxide)s, polyvinyl alcohol (PVA)s, homopolymers and copolymers of hydrolyzed polyvinyl acetate, polyvinyl formal, polyvinyl butyral, polyvinyl pyrrolidone, acrylamide having a hydrolysis degree of at least 60% and preferably at least 80%, homopolymers and copolymers of methacrylamide, homopolymers and copolymers of N-methylolacrylamide, 2-acrylamido-2-methylpropanesulfonic acid and salts thereof, and the like.

The amount of the hydrophilic resin added to the image-forming layer is preferably 2% to 40% by mass and more preferably 3% to 30% by mass of the solid content of the image-forming layer. In this range, favorable on-machine developability and a high plate wear resistance can be obtained.

To the image-recording layer, in order to improve coatability such as the coated film surface state, a surfactant, for example, a fluorine-based surfactant as described in JP1987-170950A (JP-S62-170950A) can be added. A preferred amount of the surfactant added is 0.01% to 1% by mass of the solid content of the image-forming layer.

The image-recording layer including the above-described components can be exposed along an image pattern directly by heat, for example, using a thermal head or indirectly by an infrared ray and preferably a near-infrared ray. The infrared ray is preferably converted to heat by the infrared absorbent as described above. A thermosensitive planographic printing plate precursor that is used in the invention is preferably not sensitive to visible light rays. Most preferably, the image-recording layer is not sensitive to external sunlight, that is, visible light rays (400 to 750 nm) and near UV light rays (300 to 400 nm) at an intensity and an exposure time which correspond to ordinary operation conditions so that a material can be treated with no necessity for a safe light ray environment.

<Formation of image-recording layer>

The image-recording layer is formed by dispersing or dissolving the respective necessary components described above in a solvent to prepare a coating fluid and then applying the coating fluid onto a support. Here, examples of the solvent being used can include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, water, and the like, but the solvent is not limited thereto.

These solvents are used singly or in mixture. The solid content concentration of the coating fluid is preferably 1% to 50% by mass.

In addition, the amount (solid content) of the image-recording layer applied onto the aluminum support for a planographic printing plate that is obtained after application and drying varies depending on uses; however, generally, is preferably 0.3 to 3.0 g/$m^2$. In this range, a favorable sensitivity and favorable film characteristics of the image-recording layer can be obtained.

Examples of an application method include bar coater application, rotary application, spray application, curtain application, dip application, air knife application, blade application, roll application, and the like.

[Undercoat layer]

In the planographic printing plate precursor of the embodiment of the invention, an undercoat layer is preferably provided between the above-described image-recording layer and the aluminum support for a planographic printing plate.

The undercoat layer preferably contains a compound having a support-adsorbing group and/or a hydrophilic group.

Here, the "support-adsorbing group" refers to a component enabling a compound having a support-adsorbing group to remain on the aluminum support even in a development treatment on a printer due to the interaction between the support-adsorbing group and the aluminum support. Specific examples thereof include groups and structures described below.

In addition, the "hydrophilic group" refers to a component capable of further improving the hydrophilicity of the surface of the aluminum support than in a case in which there is no hydrophilic group on the aluminum support due to the presence of a compound having a hydrophilic group on the aluminum support. Specific examples thereof include groups and structures described below. Meanwhile, the hydrophilicity of the surface can be evaluated from a contact angle obtained by a well-known method of dropping water in the air.

The support-adsorbing group is preferably a structure selected from the group consisting of an oxo acid structure of a phosphorus atom, an oxo acid salt structure of a phosphorus atom, an oxo acid ester structure of a phosphorus atom, and an oxo acid ester salt structure of a phosphorus atom, more preferably a structure selected from the group consisting of a phosphonic acid structure, a phosphonic acid salt structure, a phosphoric acid ester structure, and a phosphoric acid ester salt structure, and still more preferably a structure selected from the group consisting of a phosphoric acid ester structure and a phosphoric acid ester salt structure.

The hydrophilic group is preferably a structure selected from the group consisting of a betaine structure (zwitterionic structure), a polyalkyleneoxy structure, a sulfonic acid group, a sulfonate group, a carboxylic acid group, and a carboxylate group, more preferably a structure selected from the group consisting of a betaine structure and a polyalkyleneoxy structure, and particularly preferably a betaine structure. In the above-described aspect, the remaining of an ink on the support is suppressed, and the resistance to stains of the support being left to stand is superior.

In addition, an aspect in which the undercoat layer (particularly, a hydrophilic undercoat layer) is formed by carrying out a predetermined treatment on the surface of the support is also preferably exemplified.

For example, the surface of aluminum oxide can be silicon-oxidized by treating the surface with a sodium silicate solution of a high temperature, for example, 95°C. In addition, it is possible to apply a phosphate treatment accompanying a treatment of the surface of aluminum oxide with a phosphate solution capable of further including an inorganic fluoride. Furthermore, the surface of aluminum oxide can be washed with an organic acid and/or a salt thereof, for example, carboxylic acid, hydrocarboxylic acid, sulfonic acid, phosphonic acid, or a salt thereof, for example, succinate, phosphate, phosphonate, sulfate, and sulfonate. Citric acid or citrate is preferred. This treatment may be carried out at room temperature or at a slightly high temperature of approximately 30°C to 50°C. A more interesting treatment accompanies the washing of the surface of aluminum oxide with a bicarbonate solution. Furthermore, the surface of aluminum oxide can be treated with an acetal of polyvinyl alcohol formed by a reaction with polyvinylphosphonic acid, polyvinylmethylphosphonic acid, a phosphoric acid ester of polyvinyl alcohol, polyvinylsulfonic acid, polyvinylbenzenesulfonic acid, a sulfuric acid ester of polyvinyl alcohol, or sulfonated aliphatic aldehyde. It is clear that one or more of these post treatments can be carried out singly or in combination. More detailed description of these treatments is provided in the specifications of GB1084070B, DE4423140A, DE4417907A, EP659909B, EP537633B, DE4001466A, EP292801B, EP291760B, and US4458005A.

In addition, as another aspect of the undercoat layer, a crosslinking hydrophilic layer obtained from a hydrophilic binding agent crosslinked with a curing agent such as formaldehyde, glyoxal, polyisocyanate, or hydrolyzed tetra-alkyl orthosilicate is exemplified. The thickness of the crosslinking hydrophilic layer can be varied in a range of 0.2 to 25 μm and is preferably 1 to 10 μm. Examples of the hydrophilic binding agent for being used in the crosslinking hydrophilic layer include hydrophilic (co)polymers such as homopolymers and copolymers of vinyl alcohol, acrylamide, methylol acrylamide, methylol methacrylamide, acrylate acid, methacrylate acid, hydroxyethyl acrylate, or hydroxyethyl methacrylate or maleic anhydride/vinyl methyl ether copolymers. The hydrophilicity of a (co)polymer or a (co)polymer mixture being used is equal to or greater than the hydrophilicity of polyvinyl acetate hydrolyzed to preferably at least 60% by mass and preferably approximately 80% by mass. The amount of the curing agent, particularly, tetra-alkyl orthosilicate is preferably at least 0.2 parts by mass, more preferably 0.5 to 5 parts by mass, and most preferably 1 to 3 parts by mass per part by mass of the hydrophilic binding agent.

As a method for applying a coating fluid including constituent materials of the undercoat layer to the support, a variety of well-known methods can be used. Examples thereof include bar coater application, rotary application, spray application, curtain application, dip application, air knife application, blade application, roll application, and the like.

The amount (solid content) of the undercoat layer applied is preferably 0.1 to 100 mg/m$^2$ and more preferably 1 to 50 mg/m$^2$.

[Protective layer]

In the planographic printing plate precursor of the embodiment of the invention, in order to prevent the generation of scratches and the like in the image-recording layer, block oxygen, and prevent ablation during exposure to a high-illumination laser, a protective layer can be provided on the image-recording layer as necessary.

A variety of studies have been hitherto carried out regarding the protective layer and are described in detail in, for example, the specification of US3,458,311A and JP1980-049729B (JP-S55-049729B).

In addition, as a material that is used for the protective layer, for example, materials (water-soluble polymer compounds, inorganic lamellar compounds, and the like) described in Paragraphs [0213] to [02227] of JP2009-255434A and the like can be used.

The protective layer is formed by applying and drying a prepared protective layer coating fluid on the image-recording layer that the planographic printing plate precursor comprises on the support. An application solvent can be appropriately selected in consideration of the correlation with a binder, and, in the case of using a water-soluble polymer, distilled water or purified water is preferably used. A method for coating the protective layer is not particularly limited, and examples thereof include a blade application method, an air knife application method, a gravure application method, a roll coating application method, a spray application method, a dip application method, a bar application method, and the like.

The amount of the protective layer applied is preferably in a range of 0.01 to 10 g/m$^2$, more preferably in a range of 0.02 to 3 g/m$^2$, and most preferably in a range of 0.02 to 1 g/m$^2$ in terms of the amount applied after drying.

Examples

Hereinafter, the invention will be described in more detail on the basis of examples. Materials, amounts used, proportions, treatment contents, treatment orders, and the like described in the following examples can be appropriately changed within the scope of the gist of the invention. Therefore, the scope of the invention is not supposed to be restrictively interpreted by the examples described below.

[Example 1]

[Production of aluminum support for planographic printing plate]

In order to remove a rolling oil on the surface of a 0.3 mm-thick aluminum plate (material: JIS A 1050), a defatting treatment was carried out at 50°C for 30 seconds using an aqueous solution of 10% by mass of sodium aluminate.

After that, the surface of the aluminum plate was grained using three nylon braided brushes having a hair diameter of 0.3 mm and a water suspension of pumice having a median diameter of 25 μm (specific weight: 1.1 g/cm$^3$) and well washed with water.

Next, the aluminum plate was immersed in an aqueous solution of 25% by mass of sodium hydroxide (45°C) for nine seconds to carry out etching, washed with water, then, further immersed in an aqueous solution of 20% by mass of nitric acid at 60°C for 10 seconds, and washed with water. The amount of the grained surface etched was approximately 3 g/$m^2$.

<First electrolysis treatment>

Next, an electrochemical roughening treatment was continuously carried out using an alternating current voltage of 60 Hz. As an electrolytic solution, an aqueous solution of 1% by mass of nitric acid (including 0.5% by mass of aluminum ions) was used, and the liquid temperature was 50°C. The electrochemical roughening treatment was carried out using a trapezoidal square wave alternating current in which the time TP taken from the current value to reach the peak from zero was 0.8 msec and the duty ratio was 1:1 as the alternating current power supply waveform and a carbon electrode as a counter electrode. Ferrite was used as an auxiliary anode. The current density was 30 A/$dm^2$ at the peak current value, and, as an auxiliary anode, 5% of the current flowing out from the power supply was divided. Regarding the electric quantity in nitric acid electrolysis, the electric quantity in the aluminum plate as the anode was 175 C/$dm^2$. After that, the aluminum plate was washed with water by spraying. Furthermore, the aluminum plate was immersed in an aqueous solution of 25% by mass of sodium hydroxide (50°C) for two seconds to carry out etching, washed with water, then, further immersed in an aqueous solution of 20% by mass of nitric acid at 60°C for 10 seconds, and washed with water. The amount of the grained surface etched was approximately 1 g/$m^2$.

<Second electrolysis treatment>

Next, an electrochemical roughening treatment was carried out using the same method as for the nitric acid electrolysis under conditions of an aqueous solution of 0.62% by mass of hydrochloric acid (including 0.45% by mass of aluminum ions), an electric quantity in the aluminum plate as the anode being 50 C/$dm^2$ and a current density being 15 A/$dm^2$ in an electrolytic solution having a liquid temperature of 35°C, and then the aluminum plate was washed with water by spraying.

<Etching treatment>

Next, the aluminum plate was immersed in an aqueous solution of 5% by mass of sodium hydroxide (40°C) (including 0.05% by mass of aluminum ions) for one second to carry out etching, washed with water, then, further immersed in an aqueous solution of 20% by mass of nitric acid at 60°C for 10 seconds, and washed with water. The amount of the grained surface etched was approximately 0.2 g/$m^2$.

<Anodization treatment >

Next, a 2.5 g/$m^2$ direct current anode oxide film was provided to the aluminum plate at a current density of 20 A/$dm^2$ using an aqueous solution of 17% by mass of sulfuric acid (50°C) (including 0.75% by mass of aluminum ions) as an electrolytic solution, then, washed with water, and dried.

After that, in order to ensure the hydrophilicity of a non-image area, a silicate treatment was carried out at 60°C for 10 seconds using an aqueous solution of 2.5% by mass of No. 3 sodium silicate, and the aluminum plate was washed with water, thereby producing an aluminum support for a planographic printing plate. The amount of Si attached was 10 mg/$m^2$. The central line average roughness ($R_a$) of the support was measured using a needle having a diameter of 2 μm and turned out to be 0.51 μm.

[Production of planographic printing plate precursor]

<Formation of undercoat layer>

A coating fluid for an undercoat layer (1) having the following composition was applied onto the produced aluminum support for a planographic printing plate so that the dried coating amount reached 20 mg/$m^2$, thereby forming an undercoat layer.

(Coating fluid for undercoat layer (1))

| | |
|---|---|
| • Compound for undercoat layer (1) having following structure | 0.18 g |
| • Hydroxyethyliminodiacetic acid | 0.10 g |

(continued)

| | |
|---|---|
| • Methanol | 55.24 g |
| • Water | 6.15 g |

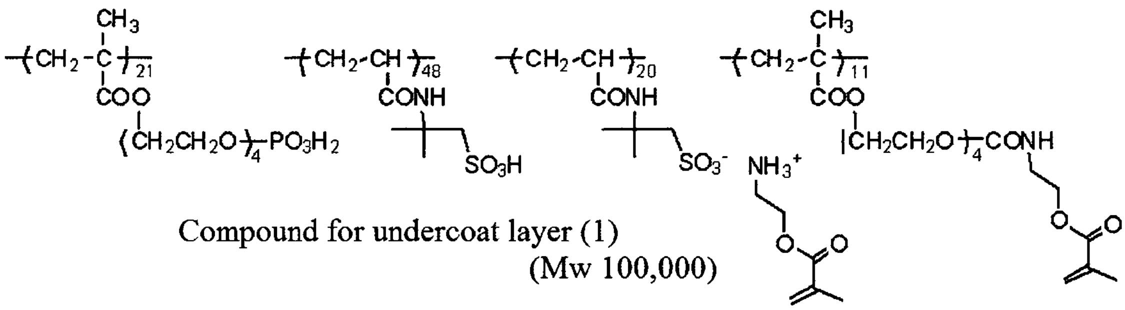

Compound for undercoat layer (1)
(Mw 100,000)

<Formation of image-recording layer>

An image-recording layer coating fluid (1) having the following composition was bar-applied onto the undercoat layer and oven-dried at 100°C for 60 seconds, thereby forming an image-recording layer having a dried coating amount of 1.0 $g/m^2$.

The image-recording layer coating fluid (1) was prepared by mixing and stirring the following photosensitive liquid and the following micro gel liquid immediately before the application.

(Photosensitive liquid)

| | | |
|---|---|---|
| • Binder polymer (1) [the following structure] | | 0.240 g |
| • Polymerization initiator (1) [the following structure] | | 0.245 g |
| • Cyanine colorant (X-1) [the following structure] | | 0.023 g |
| • Borate compound TPB [the following structure] | | 0.010 g |
| • Polymerizable monomer | Tris(acryloyloxyethyl)isocyanurate (NK ester A-9300, manufactured by Shin-Nakamura Chemical Co., Ltd.) | 0.192 g |
| • Low-molecular-weight hydrophilic compound | Tris(2-hydroxyethyl)isocyanurate | 0.062 g |
| • Low-molecular-weight hydrophilic compound (1) [the following structure] | | 0.050 g |
| • Sensitization agent | Phosphonium compound (1) [the following structure] | 0.055 g |
| • Sensitization agent | Benzyl-dimethyl-octylammonium·$PF_6$ salt | 0.018 g |
| • Sensitization agent | Ammonium group-containing polymer [the following structure, reduced specific viscosity: 44 ml/g] | 0.035 g |
| • Fluorine-based surfactant (1) [the following structure] | | 0.008 g |
| • 2-Butanone | | 1.091 g |
| • 1-Methoxy-2-propanol | | 8.609 g |

(Micro gel liquid)

| | |
|---|---|
| • Micro gel (1) prepared using following method | 2.640 g |
| • Distilled water | 2.425 g |

The structures of the binder polymer (1), the polymerization initiator (1), the cyanine colorant (X-1), the fluorine-based surfactant (1), the low-molecular-weight hydrophilic compound (1), the phosphonium compound (1), the ammonium group-containing polymer, and TPB that were used for the photosensitive liquid are as illustrated below.

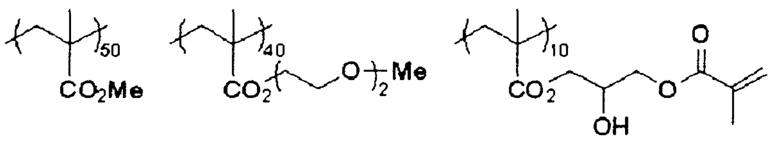

(Mw 70, 000)

Binder polymer (1)

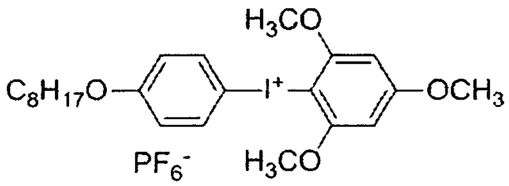

Polymerization initiator (1)

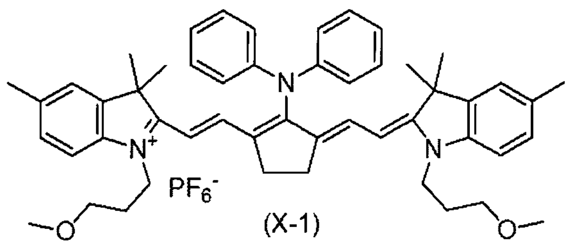

(X-1)

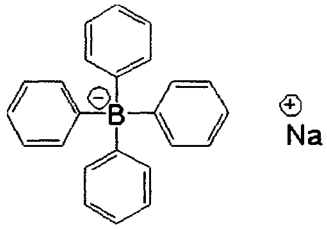

TPB

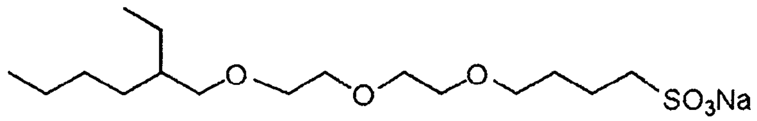

Low-molecular-weight hydrophilic compound (1)

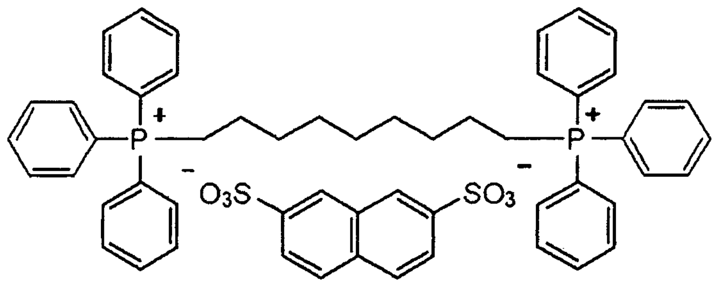

Phosphonium compound (1)

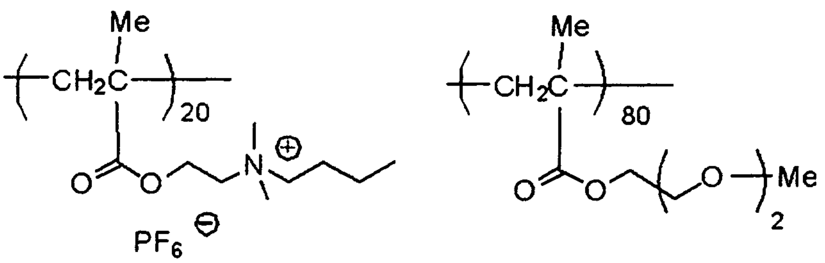

Ammonium group-containing polymer

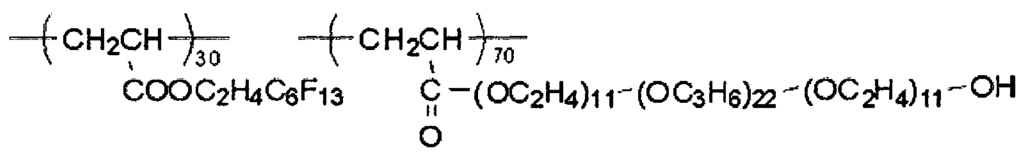

(Mw13,000)

Fluorine-based surfactant (1)

(Method for preparing micro gel (1))

As oil-phase components, a trimethylolpropane and xylene diisocyanate adduct (TAKENATE D-110N, manufactured by Mitsui Chemicals Inc.) (10 g), pentaerythritol triacrylate (SR444, manufactured by Nippon Kayaku Co., Ltd.) (3.15 g), and alkylbenzene sulfonate (PIONIN A-41C, manufactured by Takemoto Oil & Fat Co., Ltd.) (0.1 g) were dissolved in ethyl acetate (17 g). As a water-phase component, an aqueous solution of 4% by mass of polyvinyl alcohol (PVA-205, manufactured by Kuraray Co., Ltd.) (40 g) was prepared. The oil-phase components and the water-phase component were mixed together and emulsified using a homogenizer at 12,000 rpm for 10 minutes. The obtained emulsion was added to distilled water (25 g), stirred at room temperature for 30 minutes, and then stirred at 50°C for three hours. A micro gel liquid obtained as described above was diluted using distilled water so that the solid content concentration of the micro gel liquid reached 15% by mass, thereby preparing a micro gel (1). The average particle diameter of the micro gel was measured using a light scattering method and turned out to be 0.2 μm.

<Formation of protective layer>

A protective layer coating fluid having the following composition was bar-applied onto the image-recording layer

and oven-dried at 120°C for 60 seconds, thereby forming a protective layer having a dried coating amount of 0.15 g/$m^2$ and producing a planographic printing plate precursor.

(Protective layer coating fluid)

| | |
|---|---|
| • Inorganic lamellar compound dispersion liquid (1) prepared using following method | 1.5 g |
| • Polyvinyl alcohol | 0.55 g |

Aqueous solution of 6% by mass of (CKS50, manufactured by The Nippon Synthetic Chemical Industry Co., Ltd., sulfonic acid-modified, saponification degree of 99% by mol or more, polymerization degree of 300)

| | |
|---|---|
| • Polyvinyl alcohol<br>Aqueous solution of 6% by mass of (PVA-405, manufactured by Kuraray Co., Ltd., saponification degree of 81.5% by mol, polymerization degree of 500) | 0.03 g |
| • Polyoxyethylene lauryl ether<br>Aqueous solution of 1% by mass of (EMALEX 710, surfactant manufactured by Nihon Emulsion Co., Ltd.) | 0.86 g |
| • Ion exchange water | 6.0 g |

(Method for preparing inorganic lamellar compound dispersion liquid (1))

Synthetic mica (SOMASIF ME-100, manufactured by Co-op Chemical Co., Ltd.) (6.4 g) was added to ion exchange water (193.6 g) and dispersed using a homogenizer until the average particle diameter (laser scattering method) reached 3 μm. The aspect ratio of the obtained dispersion particle was 100 or more.

[Examples 2 to 12 and Comparative Examples 1 to 4]

Aluminum supports for a planographic printing plate and planographic printing plate precursors were produced using the same method as in Example 1 except for the fact that the conditions of the second electrolysis treatment and the subsequent etching treatment were changed to conditions shown in Table 1.

[Examples 13 to 19]

Aluminum supports for a planographic printing plate and planographic printing plate precursors were produced using the same method as in Example 1 except for the presence or absence of the undercoat layer and the use of a compound not having a repeating unit having a phosphoric acid group in the structure of the compound for an undercoat layer (1) instead of the compound for an undercoat layer (1) as shown in Table 1.

For the aluminum supports for a planographic printing plate produced in Examples 1 to 19 and Comparative Examples 1 to 4, the average value of the surface area-increase rates $\Delta S_{SEM}$ (%), the average value of the pit depths $\Delta h_{SEM}$ (nm), and the respective values of L*, a*, and b* in the L*a*b* color space were measured using the above-described method. The results are shown in Table 1.

[Evaluation]

<On-machine developability>

The obtained planographic printing plate precursor was exposed using Fujifilm's Luxel PLATESETTER T-6000III equipped with an infrared semiconductor laser under conditions of an outer surface drum rotation speed of 1,000 rpm, a laser output of 70%, and a resolution of 2,400 dpi. An exposed image was made to include a solid image and a 50% halftone dot chart of a 20 μm-dot FM screen.

The obtained exposed plate precursor was attached to a plate cylinder of a printer LITHRONE 26 manufactured by Komori Corporation with no development treatment. A dampening solution of Ecolity-2 (manufactured by Fujifilm Corporation)/tap water=2/98 (capacity ratio) and a Values-G(N) black ink (manufactured by DIC Corporation) were used, on-machine development was carried out by supplying the dampening solution and the ink using a standard automatic printing start method of LITHRONE 26, and then printing was carried out on 100 sheets of art (76.5 kg) paper at a printing rate of 10,000 sheets per hour.

The on-machine development of a non-exposed portion of the 50% halftone dot chart on the printer was

completed, and the number of sheets of printing paper necessary until a state in which the ink was not transferred to the halftone dot non-image area was formed was measured as the on-machine developability. The on-machine developability was evaluated as 5 (the number of damaged sheets of paper was 15 or less), 4 (the number of damaged sheets of paper was 16 to 19), 3 (the number of damaged sheets of paper was 20 to 30), 2 (the number of damaged sheets of paper was 31 to 40), and 1 (the number of damaged sheets of paper was 41 or more). The results are shown in Table 1.

<Plate wear resistance>

After on-machine development was carried out using the same printer and the same method as described above, furthermore, printing was continued. The plate wear resistance was evaluated from the number of sheets of paper printed until the beginning of a decrease in the density of the solid image was visually observed.

In a case in which the number of printed sheets of paper was less than 30,000, the plate wear resistance was evaluated as "1", in a case in which the number of printed sheets of paper was 30,000 or more and less than 35,000, the plate wear resistance was evaluated as "2", in a case in which the number of printed sheets of paper was 35,000 or more and less than 45,000, the plate wear resistance was evaluated as "3", in a case in which the number of printed sheets of paper was 45,000 or more and less than 50,000, the plate wear resistance was evaluated as "4", and, in a case in which the number of printed sheets of paper was 50,000 or more, the plate wear resistance was evaluated as "5". The results are shown in Table 1.

<Ink-removing property>

After the above-described on-machine development ended, and then a favorable printed article was obtained, a Fushion-EZ(S) ink (manufactured by DIC Corporation) to which a wax was added was applied to the non-image area of the planographic printing plate, and the number of damaged sheets of printing paper until a non-stained favorable printed article was obtained at the time of resuming printing was evaluated.

The ink-removing property was indicated as 5 (the number of damaged sheets of paper was 10 or less), 4 (the number of damaged sheets of paper was more than 10 and 20 or less), 3 (the number of damaged sheets of paper was more than 20 and 30 or less), 2 (the number of damaged sheets of paper was more than 30 and 40 or less), and 1 (the number of damaged sheets of paper was more than 40). The results are shown in Table 1.

[Table 1]

| | Second electrolysis treatment | | | | | Etching treatment | | | | Undercoat layer | | Average value of surface area-increase rates $\Delta S_{SEM}$ (%) | Pit depth $\Delta h_{SEM}$ (nm) | L*a*b* color space | | | Plate wear resistance | On-machine developability | Ink-removing property |
|---|---|---|---|---|---|---|---|---|---|---|---|---|---|---|---|---|---|---|---|
| | Liquid component | Concentration of each component (g/l) | Temperature (°C) | Current density ($A/dm^2$) | Power supply amount ($C/dm^2$) | Liquid component | Concentration of each component (g/l) | Temperature (°C) | Time (seconds) | Presence or absence | Presence or absence of difference in adsorbing group | | | L* | a* | b* | | | |
| Comparative Example I | Hydrochloric acid/Al | 6.2/4.5 | 35 | 25 | 60 | Sodium hydroxide/Al | 5%/0.5% | 40 | 5 | Present | Present | 110 | 380 | 69.0 | 1.00 | 0.10 | 1 | 5 | 5 |
| Comparative Example 2 | Hydrochloric acid/Al | 6.2/4.5 | 35 | 25 | 60 | Sodium hydroxide/Al | 5%/0.5% | 40 | 3 | Present | Present | 186 | 355 | 58.0 | 1.00 | 1.20 | 2 | 5 | 5 |
| Example 1 | Hydrochloric acid/Al | 6.2/4.5 | 35 | 15 | 50 | Sodium hydroxide/Al | 5%/0.5% | 40 | 1 | Present | Present | 200 | 160 | 54.0 | -0.43 | 1.00 | 4 | 5 | 5 |
| Example 2 | Hydrochloric acid/Al | 6.2/4.5 | 35 | 15 | 50 | Sodium hydroxide/Al | 3%/0.4% | 40 | 3 | Present | Present | 200 | 156 | 55.0 | -0.45 | 1.09 | 4 | 5 | 5 |
| Example 3 | Hydrochloric acid/Al | 6.2/4.5 | 35 | 25 | 60 | Sodium hydroxide/Al | 3%/0.4% | 40 | 2 | Present | Present | 301 | 250 | 51.0 | -1.20 | 1.00 | 5 | 5 | 5 |
| Example 4 | Hydrochloric acid/Al | 6.2/4.5 | 35 | 25 | 65 | Sodium hydroxide/Al | 3%/0.4% | 20 | 5 | Present | Present | 401 | 400 | 44.0 | -0.80 | 0.78 | 5 | 5 | 4 |
| Example 5 | Hydrochloric acid/Al | 6.2/4.5 | 35 | 15 | 65 | Sodium hydroxide/Al | 3%/0.4% | 20 | 4 | Present | Present | 480 | 154 | 40.1 | -0.78 | 0.48 | 5 | 5 | 5 |

(continued)

| | Second electrolysis treatment | | | | | Etching treatment | | | | Undercoat layer | | Average value of surface area-increase rates $\Delta S_{SEM}$ (%) | Pit depth $\Delta h_{SEM}$ (nm) | L*a*b* color space | | | Plate wear resistance | On-machine developability | Ink-removing property |
|---|---|---|---|---|---|---|---|---|---|---|---|---|---|---|---|---|---|---|---|
| | Liquid component | Concentration of each component (g/l) | Temperature (°C) | Current density (A/dm²) | Power supply amount (C/dm²) | Liquid component | Concentration of each component (g/l) | Temperature (°C) | Time (seconds) | Presence or absence | Presence or absence of difference in adsorbing group | | | L* | a* | b* | | | |
| Example 6 | Hydrochloric acid/Al | 6.2/4.5 | 35 | 25 | 65 | Sodium hydroxide/Al | 3%/0.4% | 20 | 3 | Present | Present | 630 | 370 | 39.8 | -0.98 | 0.16 | 5 | 5 | 4 |
| Example 7 | Hydrochloric acid/Al | 6.2/4.5 | 35 | 15 | 65 | Sodium hydroxide/Al | 3%/0.4% | 20 | 2 | Present | Present | 806 | 250 | 39.3 | 0.78 | -0.34 | 5 | 5 | 5 |
| Example 8 | Hydrochloric acid/Al | 6.2/4.5 | 35 | 25 | 65 | Sodium hydroxide/Al | 3%/0.4% | 20 | 2 | Present | Present | 801 | 400 | 42.0 | 0.60 | 0.20 | 5 | 5 | 4 |
| Example 9 | Hydrochloric acid/Al | 6.2/4.5 | 35 | 25 | 65 | Sodium hydroxide/Al | 3%/0.4% | 20 | 1 | Present | Present | 910 | 386 | 38.0 | -0.48 | 0.95 | 5 | 4 | 4 |
| Example 10 | Hydrochloric acid/Al | 6.2/4.5 | 35 | 10 | 65 | Sodium hydroxide/Al | 1%/0.1% | 20 | 2 | Present | Present | 1001 | 399 | 38.5 | 0.98 | -0.04 | 5 | 4 | 4 |
| Example 11 | Hydrochloric acid/Al | 6.2/4.5 | 35 | 10 | 65 | Sodium hydroxide/Al | 1%/0.1% | 20 | 1 | Present | Present | 1200 | 388 | 36.0 | 0.56 | 0.34 | 5 | 4 | 4 |
| Example 12 | Hydrochloric acid/Al | 6.2/4.5 | 35 | 10 | 65 | - | - | - | 0 | Present | Present | 1500 | 400 | 38.0 | -1.00 | 0.50 | 5 | 3 | 4 |

(continued)

| | Second electrolysis treatment | | | | | Etching treatment | | | | Undercoat layer | | Average value of surface area-increase rates $\Delta S_{SEM}$ (%) | Pit depth $\Delta h_{SEM}$ (nm) | L*a*b* color space | | | Plate wear resistance | On-machine developability | Ink-removing property |
|---|---|---|---|---|---|---|---|---|---|---|---|---|---|---|---|---|---|---|---|
| | Liquid component | Concentration of each component (g/l) | Temperature (°C) | Current density (A/dm$^2$) | Power supply amount (C/dm$^2$) | Liquid component | Concentration of each component (g/l) | Temperature (°C) | Time (seconds) | Presence or absence | Presence or absence of difference in adsorbing group | | | L* | a* | b* | | | |
| Example 13 | Hydrochloric acid/Al | 6.2/4.5 | 35 | 15 | 50 | Sodium hydroxide/Al | 3%/0.4% | 40 | 3 | Absent | - | 200 | 156 | 55.0 | -0.45 | 1.09 | 4 | 3 | 3 |
| Example 14 | Hydrochloric acid/Al | 6.2/4.5 | 35 | 15 | 50 | Sodium hydroxide/Al | 3%/0.4% | 40 | 3 | Present | Absent | 200 | 156 | 55.0 | -0.45 | 1.09 | 4 | 4 | 4 |
| Example 15 | Hydrochloric acid/Al | 6.2/4.5 | 35 | 25 | 60 | Sodium hydroxide/Al | 3%/0.4% | 40 | 1 | Absent | - | 401 | 400 | 44.0 | -0.80 | 0.78 | 5 | 3 | 3 |
| Example 16 | Hydrochloric acid/Al | 6.2/4.5 | 35 | 25 | 60 | Sodium hydroxide/Al | 3%/0.4% | 40 | 1 | Present | Absent | 401 | 400 | 44.0 | -0.80 | 0.78 | 5 | 4 | 3 |
| Example 17 | Hydrochloric acid/Al | 6.2/4.5 | 35 | 10 | 65 | - | - | - | 0 | Absent | - | 1500 | 400 | 35.0 | -0.67 | 0.76 | 5 | 3 | 3 |
| Example 18 | Hydrochloric acid/Al | 3.0/2.3 | 35 | 10 | 65 | - | - | - | 0 | Present | Absent | 1500 | 352 | 36.0 | -0.68 | 0.71 | 5 | 3 | 4 |
| Example 19 | Hydrochloric acid/Al | 2.1/1.2 | 35 | 10 | 65 | - | - | - | 0 | Present | Absent | 1500 | 251 | 37.5 | -0.70 | 0.72 | 5 | 4 | 4 |

(continued)

| | Second electrolysis treatment | | | | | Etching treatment | | | | Undercoat layer | | Average value of surface area-increase rates $\Delta S_{SEM}$ (%) | Pit depth $\Delta h_{SEM}$ (nm) | L*a*b* color space | | | Plate wear resistance | On-machine developability | Ink-removing property |
|---|---|---|---|---|---|---|---|---|---|---|---|---|---|---|---|---|---|---|---|
| | Liquid component | Concentration of each component (g/l) | Temperature (°C) | Current density (A/dm$^2$) | Power supply amount (C/dm$^2$) | Liquid component | Concentration of each component (g/l) | Temperature (°C) | Time (seconds) | Presence or absence | Presence or absence of difference in adsorbing group | | | L* | a* | b* | | | |
| Comparative Example 3 | Hydrochloric acid/Al | 6.2/4.5 | 35 | 35 | 65 | Sodium hydroxide/Al | 3%/0.4% | 40 | 3 | Present | Present | 400 | 520 | 43.0 | -0.45 | 0.78 | 5 | 2 | 2 |
| Comparative Example 4 | Hydrochloric acid/Al | 6.2/4.5 | 35 | 35 | 70 | - | - | - | 0 | Present | Present | 1200 | 900 | 31.0 | -0.56 | 0.65 | 5 | 1 | 1 |

From the results of Table 1, it was found that, in a case in which the average value of the surface area-increase rates $\Delta S_{SEM}$ (%) is less than 200%, the plate wear resistance is poor (Comparative Examples 1 and 2).

In addition, it was found that, in a case in which the average value of the pit depths $\Delta h_{SEM}$ (nm) is greater than 400 nm, the on-machine developability and the ink-removing property were poor (Comparative Examples 3 and 4).

On the other hand, it was found that, in a case in which the average value of the surface area-increase rates $\Delta S_{SEM}$ (%) of the aluminum support for a planographic printing plate is 200% or more, the average value of the pit depths $\Delta h_{SEM}$ (nm) is 400 nm or less, the aluminum support for a planographic printing plate has an excellent plate wear resistance and exhibits excellent on-machine developability in the case of being used to produce a planographic printing plate (Examples 1 to 19).

In addition, from the comparison between Example 2 and Examples 13 and 14 and the comparison between Example 9 and Examples 15 and 16, it was found that, in a case in which the undercoat layer is provided, the on-machine developability and the ink-removing property become more favorable, and, in a case in which the undercoat layer having the support-adsorbing group is provided, the on-machine developability and the ink-removing property become still more favorable.

Explanation of References

X: cross-sectional curved line
Y: standard straight line
Z: standard straight line
a: start point
b: end point
c: normal line
1: aluminum plate
2, 4: roller-shaped brush
3: abrading slurry liquid
5, 6, 7, 8: support roller
ta: anode reaction time
tc: cathode reaction time
tp: time taken for current to reach peak from zero
Ia: current at peak on anode cycle side
Ic: current at peak on cathode cycle side
50: main electrolytic vessel
51: alternating current power supply
52: radial drum roller
53a, 53b: main electrode
54: electrolytic solution supply opening
55: electrolytic solution
56: auxiliary anode
60: auxiliary anode vessel
W: aluminum plate
610: anodization treatment device
612: power supply vessel
614: electrolysis treatment vessel
616: aluminum plate
618, 626: electrolytic solution
620: power supply electrode
622, 628: roller
624: nip roller
630: electrolytic electrode
632: vessel wall
634: direct current power supply

**Claims**

1. An aluminum support for a planographic printing plate,

   wherein an average value of surface area-increase rates $\Delta S_{SEM}$ (%) computed from Expression (1) is 200% or more, and an average value of pit depths $\Delta h_{SEM}$ (nm) is 400 nm or less,
   $\Delta S_{SEM}$ (%)=(length of surface line/length of standard straight line Y)×100 ··· (1) here, the length of the standard straight line Y is 1.0 μm, and the length of the surface line is a length of a cross-sectional curved line in a cross section of the aluminum support for a planographic printing plate in a thickness direction between any start point in the cross-sectional curved line and an end point at which a length of the cross-sectional curved line from the start point is minimized among any points in the cross-sectional curved line at which a straight line distance from the start point becomes equal to the length of the standard straight line Y, and
   the pit depth $\Delta h_{SEM}$ (nm) refers to a length at which a length of a normal line drawn to a 0.2 μm-long standard straight line Z having a start point and an end point on a cross-sectional curved line, from the standard straight line Z to the cross-sectional curved line is maximized.

2. The aluminum support for a planographic printing plate according to claim 1,
   wherein a color difference of the surface satisfies $30 \leq L^* \leq 55$, $-4.0 \leq a^* \leq +4.0$, and $-4.0 \leq b^* \leq +4.0$ in a L*a*b* color space.

3. A planographic printing plate precursor comprising:

   the aluminum support for a planographic printing plate according to claim 1 or 2; and
   an image-recording layer provided on the aluminum support for a planographic printing plate.

4. The planographic printing plate precursor according to claim 3, further comprising:
   an undercoat layer between the aluminum support for a planographic printing plate and the image-recording layer.

5. The planographic printing plate precursor according to claim 4,
   wherein the undercoat layer contains a compound having at least one of a support-adsorbing group or a hydrophilic group.

6. The planographic printing plate precursor according to any one of claims 3 to 5,
   wherein the image-recording layer is an image-recording layer in which an image is formed by exposure and a non-exposed portion is removable by at least one of a printing ink or a dampening solution.

**Patentansprüche**

1. Aluminiumträger für eine Flachdruckplatte,

   worin der Mittelwert der Oberflächen-Vergrößerungsraten $\Delta S_{SEM}$ (%), berechnet dem Ausdruck (1), 200 % oder mehr beträgt und der Mittelwert der Vertiefungstiefen $\Delta h_{SEM}$ (nm) 400 nm oder weniger beträgt,

   $$\Delta S_{SEM}\ (\%) = (\text{Länge der Oberflächenlinie/Länge der geraden Standardlinie Y}) \times 100 \qquad (1)$$

   worin hier die Länge der geraden Standardlinie Y 1,0 μm beträgt und die Länge der Oberflächenlinie eine Länge einer gekrümmten Querschnittslinie in einem Querschnitt des Aluminiumträgers für eine Flachdruckplatte in Dickenrichtung zwischen einem beliebigen Startpunkt in der gekrümmten Querschnittslinie und einem Endpunkt ist, an dem, unter allen Punkten in der gekrümmten Querschnittslinie, an denen der direkte Abstand vom Startpunkt gleich zur Länge der geraden Standardlinie Y ist, die Länge der gekrümmten Querschnittslinie vom Startpunkt minimiert ist, und
   worin die Vertiefungstiefe $\Delta h_{SEM}$ (nm) eine Länge bezeichnet, bei der die Länge einer Normalen, die zu einer 0,2 μm langen geraden Standardlinie Z mit einem Startpunkt und einem Endpunkt auf einer gekrümmten Querschnittslinie gezogen wird, von der geraden Standardlinie Z zur gekrümmten Querschnittslinie maximiert ist.

2. Aluminiumträger für eine Flachdruckplatte gemäß Anspruch 1, worin der Farbunterschied der Oberfläche $30 \leq L^* \leq 55$,

$-4{,}0 \leq a^* \leq +4{,}0$ und $-4{,}0 \leq b^* \leq +4{,}0$ im L*a*b*-Farbraum erfüllt.

**3.** Flachdruckplattenvorläufer, umfassend:

einen Aluminiumträger für eine Flachdruckplatte gemäß Anspruch 1 oder 2; und
eine Bildaufzeichnungsschicht, die auf dem Aluminiumträger für eine Flachdruckplatte vorgesehen ist.

**4.** Flachdruckplattenvorläufer gemäß Anspruch 3, ferner umfassend:
eine Unterzugsschicht zwischen dem Aluminiumträger für eine Flachdruckplatte und der Bildaufzeichnungsschicht.

**5.** Flachdruckplattenvorläufer gemäß Anspruch 4, worin die Unterzugsschicht eine Verbindung mit zumindest einer an den Träger adsorbierenden Gruppe oder einer hydrophilen Gruppe umfasst.

**6.** Flachdruckplattenvorläufer gemäß irgendeinem der Ansprüche 3 bis 5, worin die Bildaufzeichnungsschicht eine Bildaufzeichnungsschicht ist, worin ein Bild durch Belichtung gebildet wird und ein nicht-belichteter Bereich durch zumindest eines von einer Drucktinte oder einer Anfeuchtlösung entfernt werden kann.

## Revendications

**1.** Support en aluminium pour une plaque d'impression planographique,

dans lequel une valeur moyenne de rapports d'augmentation de surface spécifique $\Delta S_{SEM}$ (%) calculés à partir de l'expression (1) est 200 %, ou plus, et une valeur moyenne de profondeurs de creux $\Delta h_{SEM}$ (nm) est 400 nm ou moins,

$$\Delta S_{SEM}\ (\%) = (\text{longueur d'une ligne de surface/longueur d'une ligne droite standard Y}) * 100 \cdots (1)$$

ici, la longueur de la ligne droite standard Y est 1,0 µm et la longueur de la ligne de surface est une longueur d'une ligne incurvée transversale dans une coupe transversale du support en aluminium pour une plaque d'impression planographique dans le sens de l'épaisseur entre n'importe quel point de départ de la ligne incurvée transversale et un point d'arrivée où une longueur de la ligne incurvée transversale à partir du point de départ est réduite à un minimum parmi tous les points de la ligne incurvée transversale où une distance de ligne droite à partir du point de départ devient égal à la longueur de la ligne droite standard Y et
la profondeur de creux $\Delta h_{SEM}$ (nm) se réfère à une longueur à laquelle une longueur d'une ligne normale tracée par rapport à une ligne droite standard longue de 0,2 µm Z présentant un point de départ et un point d'arrivée sur une ligne incurvée transversale, de la ligne droite standard Z à la ligne incurvée transversale est maximisée.

**2.** Support en aluminium pour une plaque d'impression planographique selon la revendication 1,
dans lequel une différence de couleur de la surface satisfait $30 \leq L^* < 55$, $-4{,}0 \leq a^* < +4{,}0$ et $-4{,}0 \leq b^* \leq +4{,}0$ dans un espace colorimétrique L*a*b*.

**3.** Précurseur de plaque d'impression planographique comprenant :

le support en aluminium pour une plaque d'impression planographique selon la revendication 1 ou 2 ; et
une couche d'enregistrement d'image disposée sur le support en aluminium pour une plaque d'impression planographique.

**4.** Précurseur de plaque d'impression planographique selon la revendication 3, comprenant en outre :
une sous-couche entre le support en aluminium pour une plaque d'impression planographique et la couche d'enregistrement d'image.

**5.** Précurseur de plaque d'impression planographique selon la revendication 4,
dans lequel la sous-couche contient un composé présentant au moins l'un d'un groupe d'adsorption de support ou d'un groupe hydrophile.

6. Précurseur de plaque d'impression planographique selon l'une quelconque des revendications 3 à 5, dans lequel la couche d'enregistrement d'image est une couche d'enregistrement d'image dans laquelle une image est formée par exposition et une partie non exposée peut être retirée par au moins l'une d'une encre d'impression ou d'une solution de mouillage.

FIG. 1

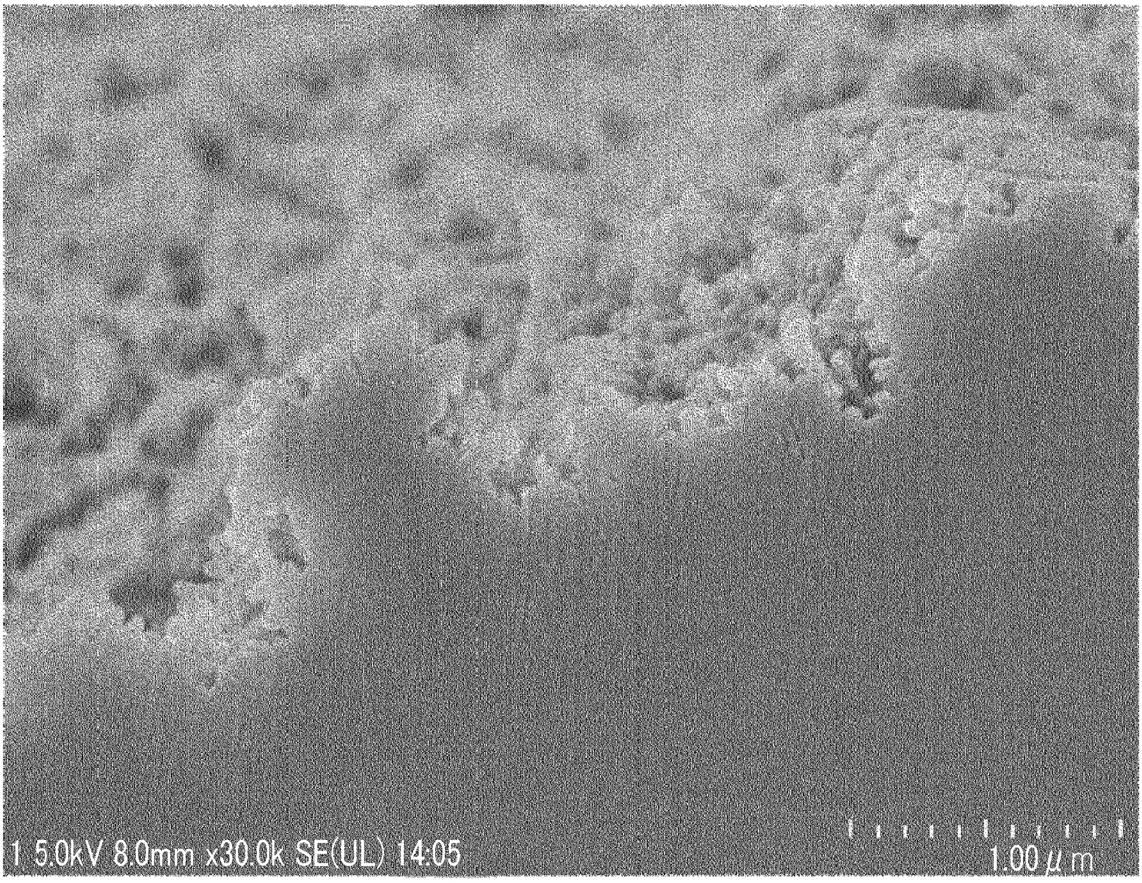

FIG. 2

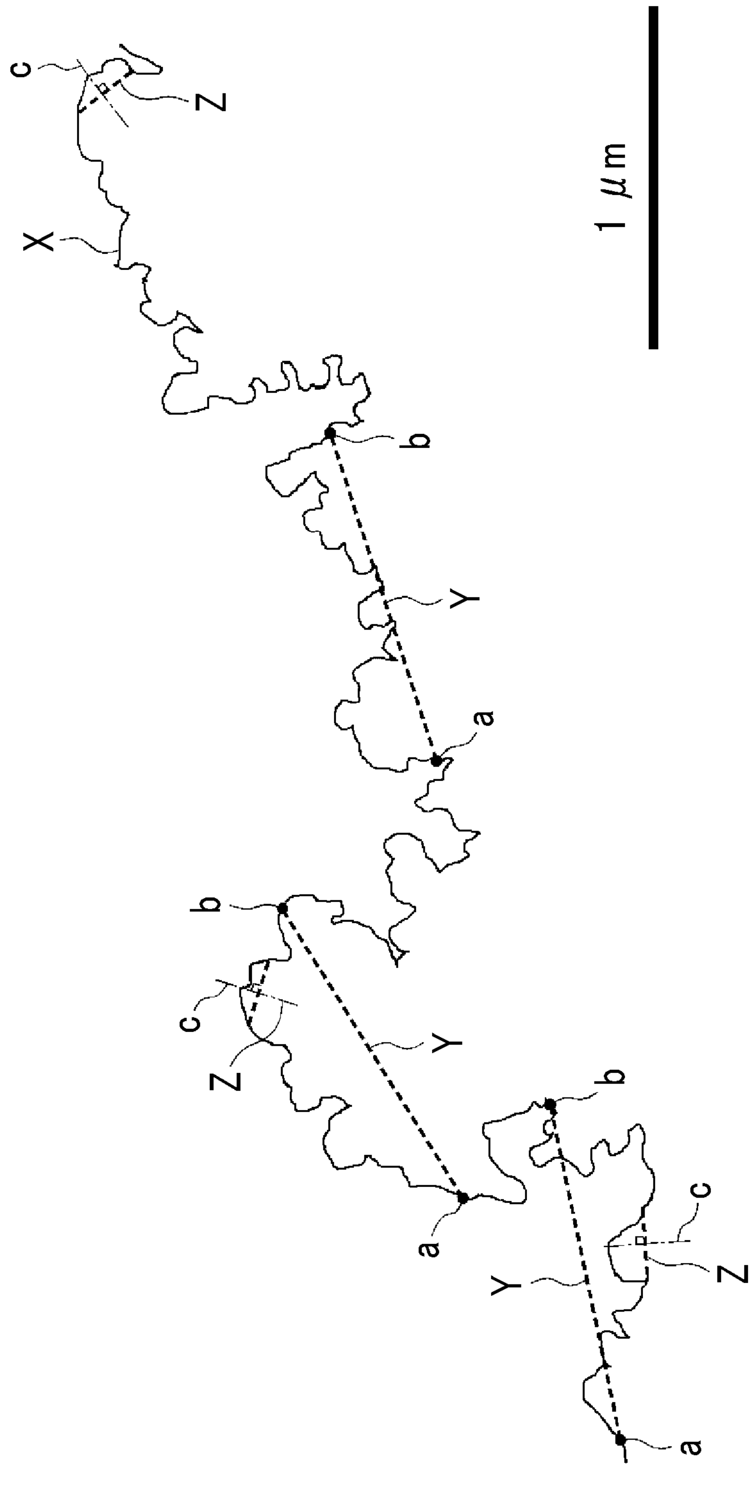

FIG. 3

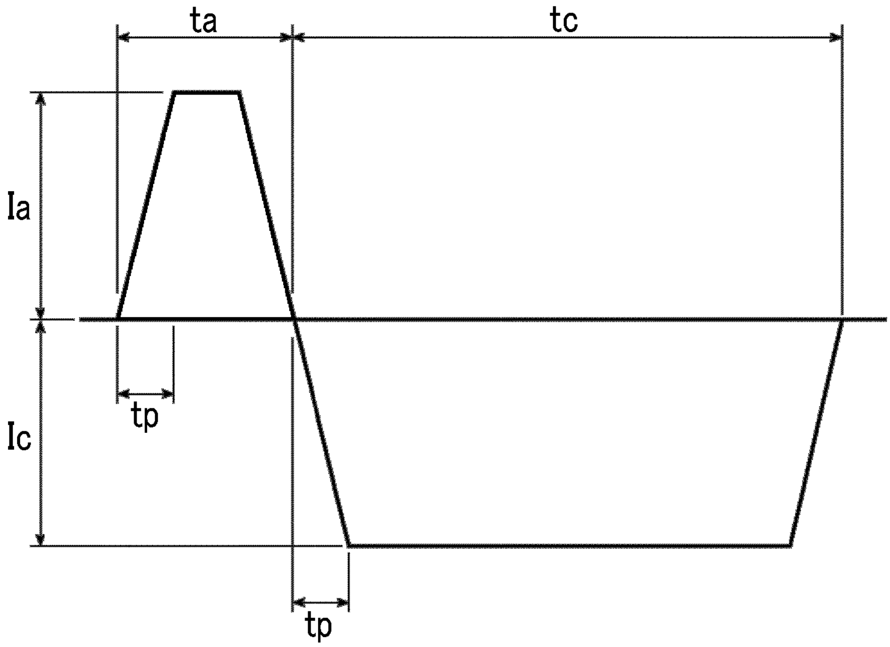


FIG. 4

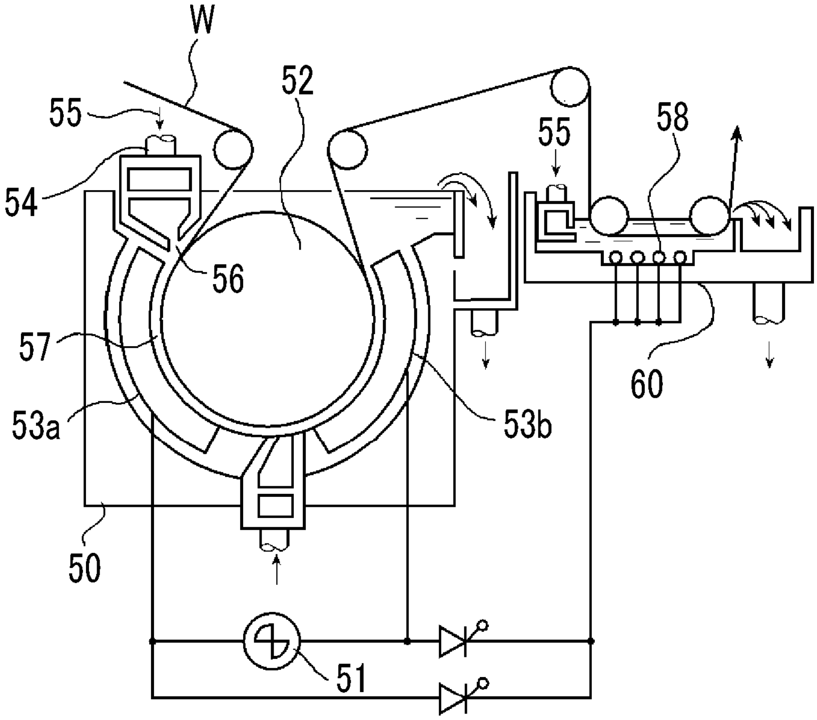

FIG. 5

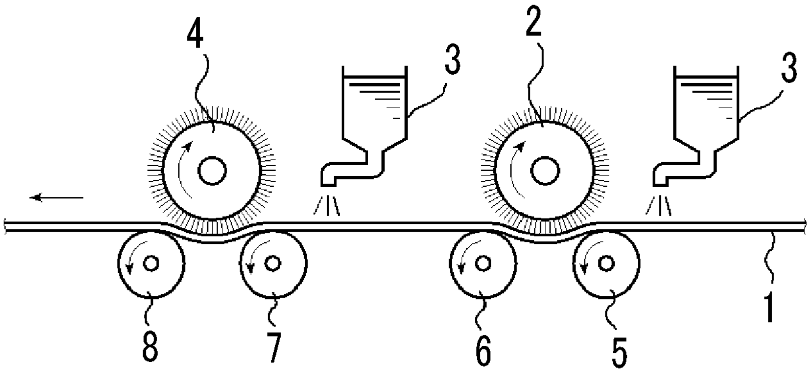


FIG. 6

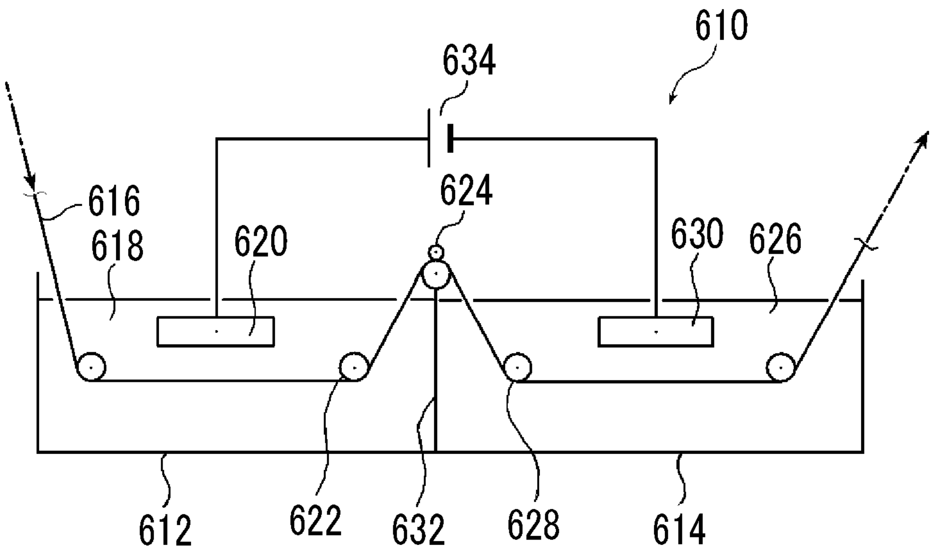

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004114324 A
- JP 2004114677 A
- US 2012189959 A1
- JP 48018327 B
- JP S48018327 B
- JP 50040047 B
- JP S50040047 B
- GB 1412768 B
- JP 2005254638 A
- US 2714066 A
- US 3181461 A
- JP 5195300 A
- JP H5195300 A
- JP 2003001956 A
- JP 2009255434 A
- JP 48041708 B
- JP S48041708 B
- EP 1219416 B
- EP 823327 B
- EP 978376 B
- EP 1029667 B
- EP 1053868 B
- EP 1093934 B
- WO 97039894 A
- WO 00029214 A
- EP 400706 B
- JP 62170950 A
- JP S62170950 A
- GB 1084070 B
- DE 4423140 A
- DE 4417907 A
- EP 659909 B
- EP 537633 B
- DE 4001466 A
- EP 292801 B
- EP 291760 B
- US 4458005 A
- US 3458311 A
- JP 55049729 B
- JP S55049729 B

### Non-patent literature cited in the description

- *Particulate Science and Technology,* 1989, vol. 7, 223-228